# EUROPEAN PATENT APPLICATION

(11) **EP 4 773 751 A1**
(43) Date of publication of application: **08.07.2026**
(21) Application number: 25227546.6
(22) Date of filing: 30.12.2025
(51) Int. Cl.: H10B 12/00

(54) **SEMICONDUCTOR MEMORY DEVICE INCLUDING CONDUCTIVE LAYERS WITH REDUCED SURFACE ENERGY**

(30) Priority: 02.01.2025 KR 20250000459
(71) Applicant: Samsung Electronics Co., Ltd., Suwon-si, Gyeonggi-do 16677 (KR)
(72) Inventor: PARK, Wonjun, 16677 Suwon-si, Gyeonggi-do (KR); JEONG, Eulji, 16677 Suwon-si, Gyeonggi-do (KR); KIM, Sukhoon, 16677 Suwon-si, Gyeonggi-do (KR); HAN, Jaehun, 16677 Suwon-si, Gyeonggi-do (KR)
(74) Representative: Kuhnen & Wacker Patent- und Rechtsanwaltsbüro PartG mbB

(57) **Abstract**

A semiconductor memory device includes a plurality of semiconductor patterns (AP), a plurality of bit lines (BL), a plurality of word lines (WL), and a plurality of cell capacitors (CAP). Each of the plurality of semiconductor patterns (AP) includes a first end portion and a second end portion. Each of the plurality of bit lines (BL) is coupled with the first end portion of each of the plurality of semiconductor patterns (AP). Each of the plurality of word lines (WL) includes a first conductive layer including a first molybdenum, Mo, derivative having a first composition, a second conductive layer including a second molybdenum, Mo, derivative having a second composition different from the first composition, and a third conductive layer including a third molybdenum, Mo, derivative having a third composition different from the second composition. Each of the plurality of cell capacitors (CAP) is coupled with the second end portion of each of the plurality of semiconductor patterns (AP).

## Description

### 1. Field

The present disclosure relates generally to semiconductor memory devices, and more particularly, to a three-dimensional (3D) semiconductor memory device including conductive layers with reduced surface energy.

### 2. Description of Related Art

High-capacity semiconductor memory devices may be needed as electronic products are required to be further miniaturized, provide multifunctional features, and/or have a relatively high performance level. In addition, an increased degree of integration may be needed to provide relatively high-capacity semiconductor memory devices. Three-dimensional (3D) semiconductor memory devices may have been proposed to potentially increase memory capacity by stacking a plurality of memory cells in a vertical direction on a substrate.

### SUMMARY

One or more example embodiments of the present disclosure provide a three-dimensional (3D) semiconductor memory device including conductive layers with reduced surface energy and capable of having increased memory capacity.

According to an aspect of the present disclosure, a semiconductor memory device includes a plurality of semiconductor patterns, a plurality of bit lines, a plurality of word lines, and a plurality of cell capacitor. The plurality of semiconductor patterns extend in a first horizontal direction on a substrate, and are spaced apart from each other in a second horizontal crossing the first horizontal direction and a vertical direction. Each of the plurality of semiconductor patterns includes a first end portion and a second end portion. The plurality of bit lines extend in the vertical direction. Each of the plurality of bit lines is coupled with the first end portion of each of the plurality of semiconductor patterns. The plurality of word lines extend in a second horizontal direction and at least partially surround the plurality of semiconductor patterns, respectively. Each of the plurality of word lines include a first conductive layer including a first molybdenum (Mo) derivative having a first composition, a second conductive layer including a second molybdenum (Mo) derivative having a second composition different from the first composition, and a third conductive layer including a third molybdenum (Mo) derivative having a third composition different from the second composition. Each of the plurality of cell capacitors is coupled with the second end portion of each of the plurality of semiconductor patterns.

According to an aspect of the present disclosure, a semiconductor memory device includes a plurality of semiconductor patterns, a plurality of bit lines, a plurality of word lines, a gap-fill insulating layer, a gate insulating layer, and a plurality of cell capacitors. The plurality of semiconductor patterns extend in a first horizontal direction on a substrate, and are spaced apart from each other in a second horizontal crossing the first horizontal direction and a vertical direction. Each of the plurality of semiconductor patterns includes a first end portion and a second end portion. The plurality of bit lines extend in the vertical direction. Each of the plurality of bit lines is coupled with the first end portion of each of the plurality of semiconductor patterns. The plurality of word lines extend in a second horizontal direction and at least partially surround the plurality of semiconductor patterns, respectively. Each of the plurality of word lines includes a first conductive layer including a first molybdenum (Mo) derivative, a second conductive layer including a second molybdenum (Mo) derivative, and a third conductive layer including a third molybdenum (Mo) derivative. The gap-fill insulating layer is between two word lines adjacent to each other in the vertical direction from among the plurality of word lines. The gate insulating layer is between the gap-fill insulating layer and the plurality of word lines and between the plurality of semiconductor patterns and the plurality of word lines. Each of the plurality of cell capacitors is coupled with the second end portion of each of the plurality of semiconductor patterns. The first molybdenum (Mo) derivative includes a first additive element in a first content. The second molybdenum (Mo) derivative includes a second additive element in a second content greater than the first content. The third molybdenum (Mo) derivative includes a third additive element in a third content greater than the second content.

According to an aspect of the present disclosure, a semiconductor memory device includes a plurality of semiconductor patterns, a plurality of bit lines, a plurality of word lines, a gap-fill insulating layer, a gate insulating layer, and a plurality of cell capacitors. The plurality of semiconductor patterns extend in a first horizontal direction on a substrate, and are spaced apart from each other in a second horizontal crossing the first horizontal direction and a vertical direction. Each of the plurality of semiconductor patterns include a first end portion and a second end portion. The plurality of bit lines extend in the vertical direction. Each of the plurality of bit lines is coupled with the first end portion of each of the plurality of semiconductor patterns. The plurality of word lines extend in a second horizontal direction and at least partially surround the plurality of semiconductor patterns, respectively. The gap-fill insulating layer is between two word lines adjacent to each other in the vertical direction from among the plurality of word lines. The gate insulating layer is between the gap-fill insulating layer and the plurality of word lines and between the plurality of semiconductor patterns and the plurality of word lines. Each of the plurality of cell capacitors is coupled with the second end portion of each of the plurality of semiconductor patterns. Each of the plurality of word lines includes a first conductive layer, a second conductive layer, and a third conductive layer. The first conductive layer at least partially surrounds each of the plurality of semiconductor patterns on the gate insulating layer and includes a first molybdenum (Mo) derivative having a first composition. The second conductive layer at least partially surrounds each of the plurality of semiconductor patterns on the first conductive layer and includes a second molybdenum (Mo) derivative having a second composition different from the first composition. The third conductive layer at least partially surrounds each of the plurality of semiconductor patterns on the second conductive layer and includes a third molybdenum (Mo) derivative having a third composition different from the second composition.

Additional aspects may be set forth in part in the description which follows and, in part, may be apparent from the description, and/or may be learned by practice of the presented embodiments.

### BRIEF DESCRIPTION OF DRAWINGS

The above and other aspects, features, and advantages of certain embodiments of the present disclosure may be more apparent from the following description taken in conjunction with the accompanying drawings in which:
FIG. 1 is a block diagram schematically illustrating a semiconductor memory device, according to some embodiments;
FIG. 2 is a circuit diagram illustrating a cell array region, according to some embodiments;
FIG. 3 is a schematic perspective view illustrating a memory cell region of FIG. 1, according to some embodiments;
FIG. 4 is a plan view at a first vertical level of FIG. 3, according to some embodiments;
FIG. 5 is a cross-sectional view taken along line A-A' of FIG. 3, according to some embodiments;
FIG. 6 is a cross-sectional view taken along line B-B' of FIG. 3, according to some embodiments;
FIG. 7 is an enlarged view of a portion EN1 of FIG. 4, according to some embodiments;
FIG. 8 is an enlarged view of a portion EN2 of FIG. 5, according to some embodiments;
FIG. 9 is an enlarged view of a portion EN3 of FIG. 6, according to some embodiments;
FIG. 10 is a graph schematically illustrating surface energy of a word line, according to some embodiments;
FIGS. 11 and 12 are schematic diagrams illustrating a semiconductor memory device, according to some embodiments;
FIG. 13 is a schematic diagram illustrating a semiconductor memory device, according to some embodiments;
FIG. 14 is a schematic diagram illustrating a semiconductor memory device, according to some embodiments; and
FIGS. 15 to 31 are schematic diagrams illustrating a method of manufacturing a semiconductor memory device, according to some embodiments.

### DETAILED DESCRIPTION

The following description with reference to the accompanying drawings is provided to assist in a comprehensive understanding of embodiments of the present disclosure defined by the claims and their equivalents. Various specific details are included to assist in understanding, but these details are considered to be exemplary only. Therefore, those of ordinary skill in the art may recognize that various changes and modifications of the embodiments described herein may be made without departing from the scope of the disclosure. In addition, descriptions of well-known functions and structures are omitted for clarity and conciseness.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The terms "upper," "middle", "lower", and the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", and the like may be used to distinguish components from each other and do not limit the present disclosure. For example, the terms "first", "second", "third", and the like may not necessarily involve an order or a numerical meaning of any form.

As used herein, when an element or layer is referred to as "covering", "overlapping", or "surrounding" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

As used herein, each of the terms "AlO", "BaSrTiO", "BaTiO", "BiFeO", "HfO", "HfON", "HfSiO", "HfSiON", "InGaO", "InGaZnO", "InZnO", "IrO₂", "LaAlO", "LaN", "LaO", "MoS₂", "MoSiN", "MoSiNH", "NbN", "Nb₂O₅", "PbScTaO", "PbZrTiO", "SiGe", "Si₃N₄", "SiO₂", "SiON", "SrTaBiO", "SrTiO", "TaN", "TaO", "TaSiN", "TiAlC", "TiAlN", "TiN", "TiO", "TiSiN", "TiSiN", "WN", "WSe₂", "WSiN", "YO", "ZrO", "ZrON", "ZrSiO", "ZrSiON", and the like may refer to a material made of elements included in each of the terms and is not a chemical formula representing a stoichiometric relationship.

Hereinafter, various embodiments of the present disclosure are described with reference to the accompanying drawings.

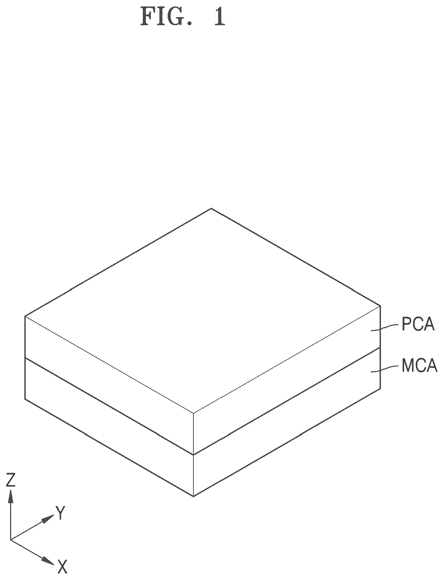

FIG. 1 is a block diagram schematically illustrating a semiconductor memory device 100, according to some embodiments.

Referring to FIG. 1, the semiconductor memory device 100 may include a cell array region MCA and a peripheral circuit region PCA disposed at a higher vertical level than the cell array region MCA.

In some embodiments, the cell array region MCA may be and/or may include a memory cell region of a dynamic random access memory (DRAM) device, and the peripheral circuit region PCA may be and/or may include a core region and/or a peripheral circuit region of the DRAM device. For example, the peripheral circuit region PCA may include a peripheral circuit transistor for transmitting signals and/or power to a memory cell array included in the cell array region MCA. In some embodiments, the peripheral circuit transistor may include various circuits such as, but not limited to, a command decoder, a control logic, an address buffer, a row decoder, a column decoder, a sense amplifier, a data input/output (I/O) circuit, or the like.

Although FIG. 1 illustrates a case where the peripheral circuit region PCA is disposed at a higher vertical level than the cell array region MCA (e.g., when the peripheral circuit region PCA is disposed on the cell array region MCA), embodiments of the present disclosure are not limited in this regard. In some embodiments, the semiconductor memory device 100 may be upside down so that the cell array region MCA may be at a higher vertical level than the peripheral circuit region PCA.

In some embodiments, the peripheral circuit region PCA and the cell array region MCA may be formed on individual wafers, and the peripheral circuit region PCA and the cell array region MCA may be attached to each other using a bonding pad. In some embodiments, the peripheral circuit region PCA may be formed on a peripheral circuit wafer, and the cell array region MCA may be formed on the peripheral circuit region PCA.

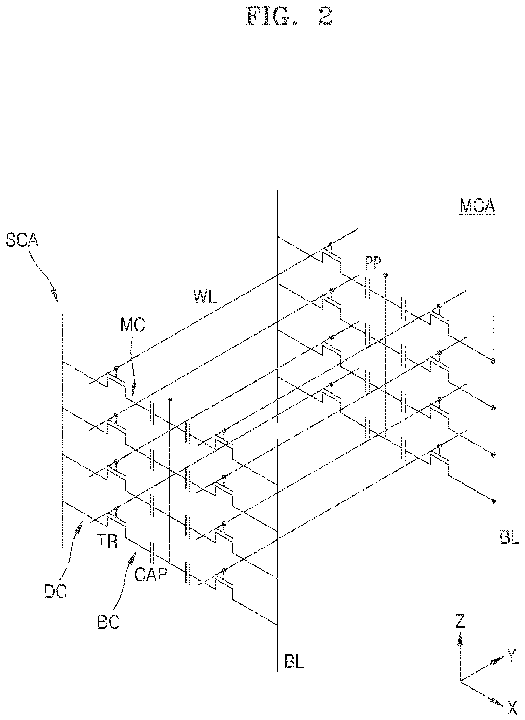

FIG. 2 is a circuit diagram illustrating a cell array region, according to some embodiments.

Referring to FIG. 2, the cell array region MCA may include a plurality of sub-cell arrays SCA. The plurality of sub-cell arrays SCA may be arranged to be spaced apart from each other in a second horizontal direction Y.

The sub-cell array SCA may include a plurality of bit lines BL, a plurality of word lines WL, and a plurality of memory cells MC. Each of the plurality of memory cells MC may include a cell transistor TR and a cell capacitor CAP connected thereto. Each of the plurality of memory cells MC may have a one-transistor one-capacitor (1T1C) structure.

The plurality of word lines WL may extend in the second horizontal direction Y and may be disposed to be spaced apart from each other in a first horizontal direction X and a vertical direction Z. The plurality of bit lines BL may extend in the vertical direction Z and may be disposed to be spaced apart from each other in each of the first horizontal direction X and the second horizontal direction Y. The cell transistor TR may be disposed between a word line WL and a bit line BL.

A gate of the cell transistor TR may be connected to the word line WL, and a source of the cell transistor TR may be connected to the bit line BL through a first contact DC. The cell transistor TR may be connected to the cell capacitor CAP through a second contact BC. A drain of the cell transistor TR may be connected to a first electrode of the cell capacitor CAP through the second contact BC, and a second electrode of the cell capacitor CAP may be connected to a plate electrode PP.

In a sub-cell array SCA, a plurality of cell transistors TR may be disposed at positions overlapping each other in the vertical direction Z. In a sub-cell array SCA, a plurality of cell capacitors CAP may be disposed at positions overlapping each other in the vertical direction Z. The cell transistor TR and the cell capacitor CAP may be disposed side by side at the same vertical level, and the plurality of memory cells MC including the cell transistor TR and the cell capacitor CAP may be stacked in the vertical direction Z. The storage capacity of the sub-cell array SCA may vary depending on the number of layers of the plurality of memory cells MC stacked in the vertical direction Z (e.g., the number of layers of the plurality of cell capacitors CAP).

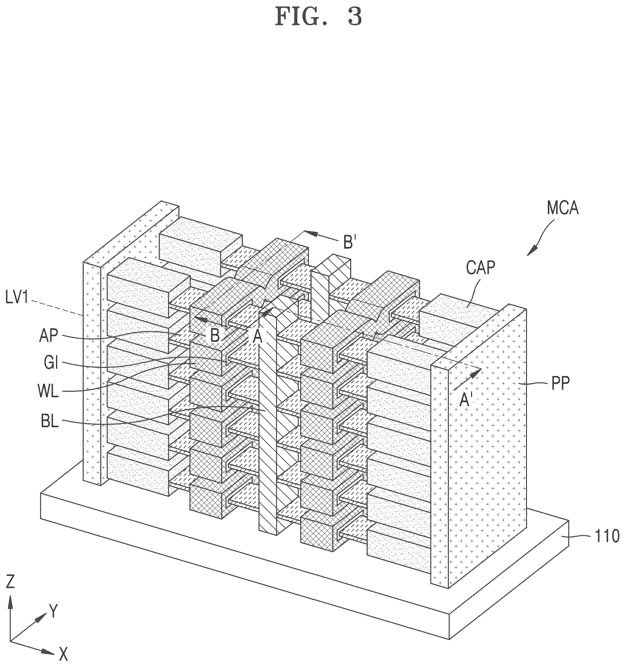

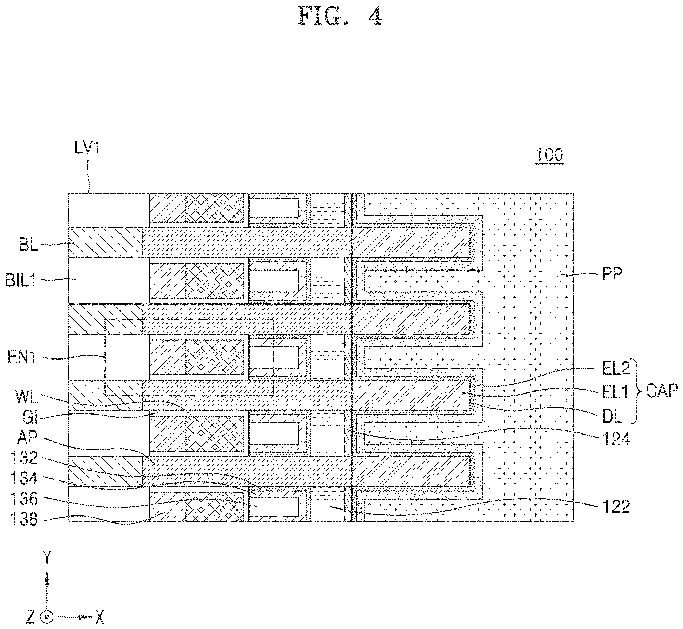

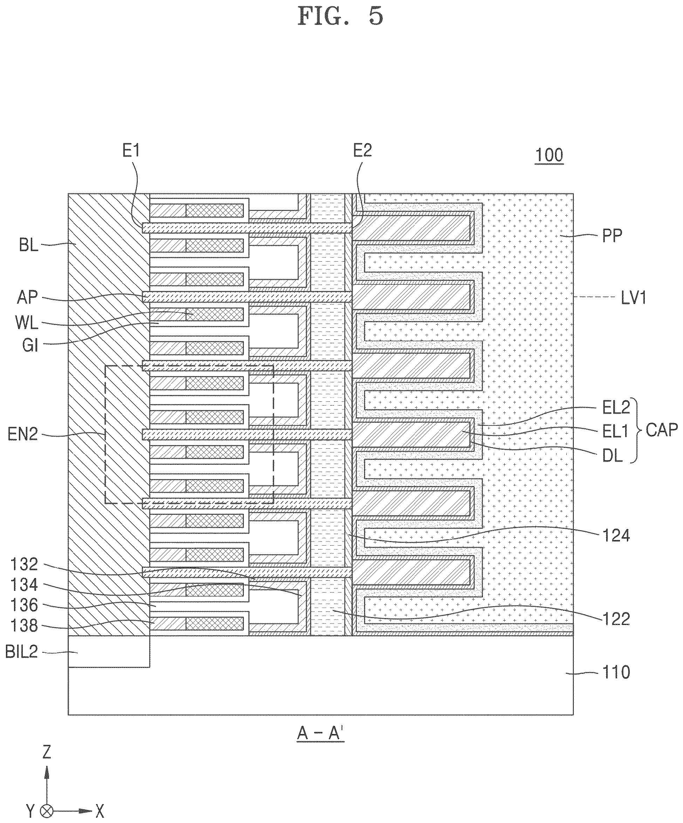

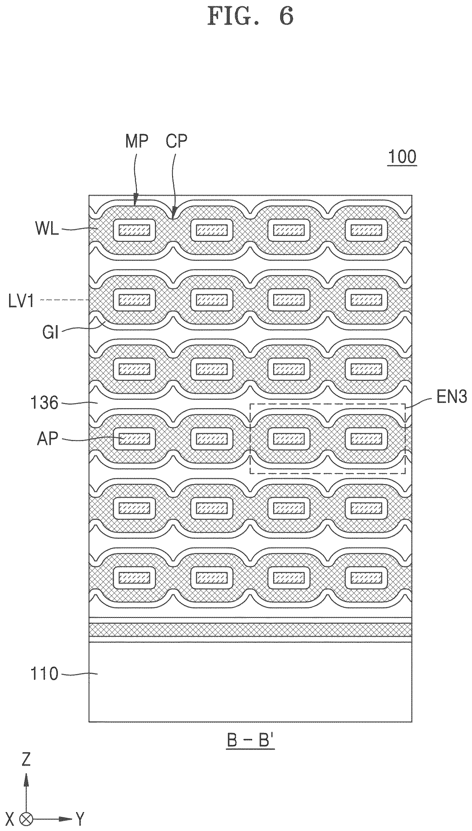

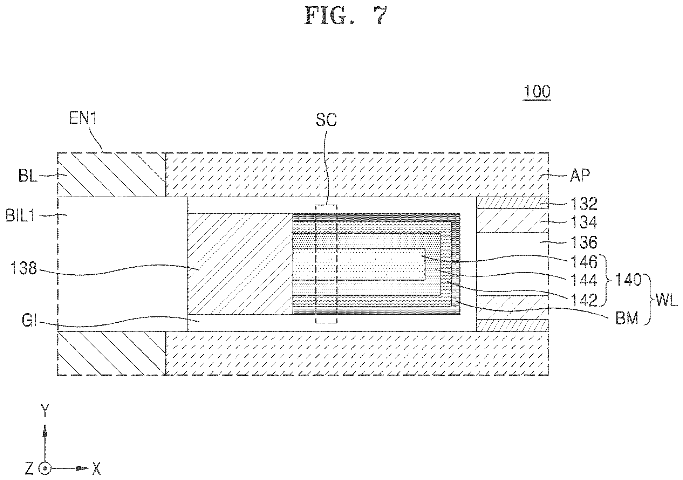

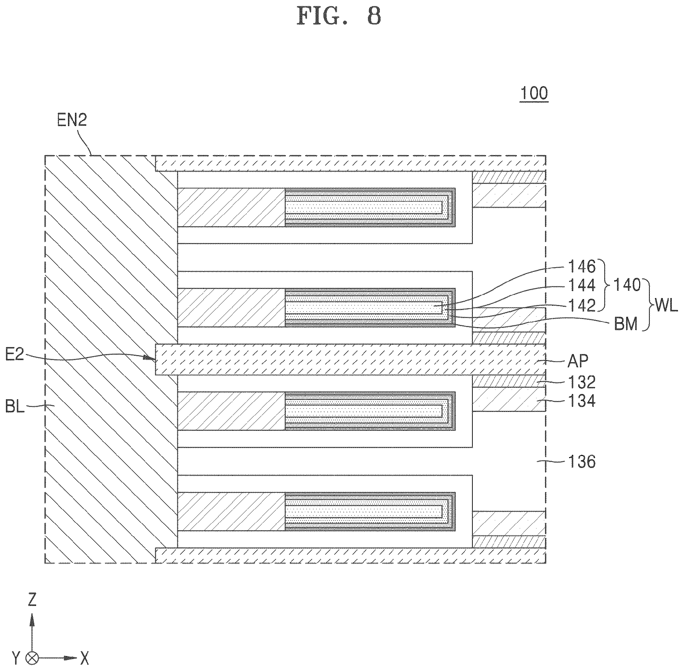

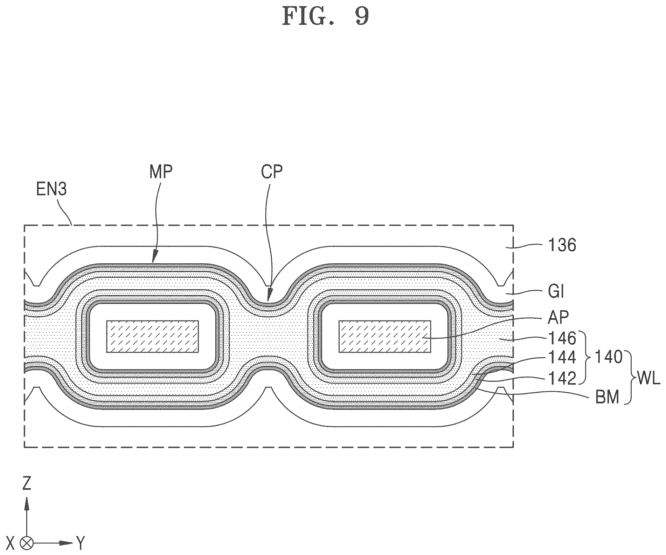

FIG. 3 is a schematic perspective view illustrating the cell array region MCA of FIG. 1, according to some embodiments. FIG. 4 is a plan view at a first vertical level LV1 of FIG. 3, according to some embodiments. FIG. 5 is a cross-sectional view taken along line A-A' of FIG. 3, according to some embodiments. FIG. 6 is a cross-sectional view taken along line B-B' of FIG. 3, according to some embodiments. FIG. 7 is an enlarged view of a portion EN1 of FIG. 4, according to some embodiments. FIG. 8 is an enlarged view of a portion EN2 of FIG. 5, according to some embodiments. FIG. 9 is an enlarged view of a portion EN3 of FIG. 6, according to some embodiments.

Referring to FIGS. 3 to 9, a plurality of semiconductor patterns AP may extend in the first horizontal direction X and may be disposed to be spaced apart from each other in the second horizontal direction Y and the vertical direction Z on a substrate 110 in the cell array region MCA.

In some embodiments, the substrate 110 may include silicon (Si), germanium (Ge), or silicon-germanium (SiGe). In some embodiments, the substrate 110 may include a silicon-on-insulator (SOI) substrate or a germanium-on-insulator (GeOI) substrate.

In some embodiments, the plurality of semiconductor patterns AP may include, for example, an undoped semiconductor material and/or a doped semiconductor material. In some embodiments, the plurality of semiconductor patterns AP may include polysilicon. In some embodiments, the plurality of semiconductor patterns AP may include an amorphous metal oxide, a polycrystalline metal oxide, or a combination of the amorphous metal oxide and the polycrystalline metal oxide, and may include, for example, at least one of indium-gallium-based oxide (InGaO), indium-zinc-based oxide (InZnO), or indium-gallium-zinc-based oxide (InGaZnO). In some embodiments, the plurality of semiconductor patterns AP may include a two-dimensional (2D) material semiconductor, and the 2D material semiconductor may include, for example, molybdenum sulfide (MoS₂), tungsten selenide (WSe₂), graphene, carbon nanotube, or a combination thereof.

A plurality of word lines WL may be disposed to be spaced apart from each other in the vertical direction Z, and may be respectively disposed on upper surfaces, bottom surfaces, and sidewalls of the plurality of semiconductor patterns AP to extend in the second horizontal direction Y. One of the plurality of word lines WLs may surround the plurality of semiconductor patterns AP disposed to be spaced apart in the second horizontal direction Y and may extend in the second horizontal direction Y. Two of the plurality of word lines WL spaced apart from each other in the vertical direction Z may be disposed at positions overlapping each other in the vertical direction Z. As the plurality of word lines WL are disposed to surround the upper surfaces, the bottom surfaces, and the sidewalls of the plurality of semiconductor patterns AP, the semiconductor memory device 100 may be referred to as a gate all around-type device.

In some embodiments, the plurality of word lines WL may include a barrier metal layer BM and a word line conductive layer 140. In some embodiments, the word line conductive layer 140 may include a molybdenum (Mo)-based metal derivative, and may include, for example, a first conductive layer 142, a second conductive layer 144, and a third conductive layer 146 sequentially disposed on the barrier metal layer BM. The word line conductive layer 140 may include the molybdenum (Mo)-based metal derivative, and accordingly, the word line conductive layer 140 may have a relatively low resistivity.

In some embodiments, the barrier metal layer BM may include at least one of titanium (Ti), titanium nitride (TiN), titanium aluminum carbide (TiAIC), titanium aluminum nitride (TiAIN), titanium silicon nitride (TiSiN), molybdenum silicon nitride (MoSiN), tungsten nitride (WN), tungsten silicon nitride (WSiN), tantalum (Ta), tantalum silicon nitride (TaSiN), tantalum nitride (TaN), or lanthanum nitride (LaN). In some embodiments, the barrier metal layer BM may be omitted. In some embodiments, the barrier metal layer BM may have a thickness of 0.1 nanometer (nm) to 5.0 nm.

In some embodiments, the first conductive layer 142 may include a first molybdenum (Mo) derivative. In some embodiments, the first molybdenum (Mo) derivative may include metal molybdenum as a main component, but may include a first additive element of at least one of oxygen (O), chlorine (CI), nitrogen (N), hydrogen (H), carbon (C), or silicon (Si) in a first content. In some embodiments, the first content of the first additive element may have a range from 0.01 atomic percentage (at%) to 20 at%. That is, the first molybdenum (Mo) derivative may be represented as a chemical formula similar to MoM₁ₓ, where M₁ may include at least one of oxygen (O), chlorine (CI), nitrogen (N), hydrogen (H), carbon (C), or silicon (Si), and x may represent an atomic percentage greater than or equal to 0.01 at% and less than or equal to 20 at% (e.g., 0.01 at% ≤ x ≤ 20 at%). In some embodiments, the first molybdenum (Mo) derivative constituting the first conductive layer 142 may have lower surface energy than metal molybdenum (e.g., pure metal molybdenum that does not include an additive element or pure metal molybdenum into which an additive element is not intentionally doped or injected).

In some embodiments, the second conductive layer 144 may include a second molybdenum (Mo) derivative. In some embodiments, the second molybdenum (Mo) derivative may include metal molybdenum as a main component, but may include a second additive element of at least one of oxygen (O), chlorine (CI), nitrogen (N), hydrogen (H), carbon (C), or silicon (Si) in a second content. In some embodiments, the second content of the second additive element may have a range from 15 at% to 40 at%. That is, the second molybdenum (Mo) derivative may be represented as a chemical formula similar to MoM_{2y}, where M₂ may include at least one of oxygen (O), chlorine (CI), nitrogen (N), hydrogen (H), carbon (C), or silicon (Si), and y may represent an atomic percentage greater than or equal to 15 at% and less than or equal to 40 at% (e.g., 15 at% ≤ y ≤ 40 at%). In some embodiments, the second molybdenum (Mo) derivative constituting the second conductive layer 144 may have lower surface energy than the first molybdenum (Mo) derivative constituting the first conductive layer 142, or may have lower surface energy than metal molybdenum (e.g., pure metal molybdenum that does not include an additive element or pure metal molybdenum into which an additive element is not intentionally doped or injected).

In some embodiments, the third conductive layer 146 may include a third molybdenum (Mo) derivative. In some embodiments, the third molybdenum (Mo) derivative may include metal molybdenum as a main component, but may include a third additive element of at least one of oxygen (O), chlorine (CI), nitrogen (N), hydrogen (H), carbon (C), or silicon (Si) in a third content. In some embodiments, the third content of the third additive element may have a range from 40 at% to 85 at%. That is, the third molybdenum (Mo) derivative may be represented as a chemical formula similar to MoM_{3z'} where M₃ may include at least one of oxygen (O), chlorine (CI), nitrogen (N), hydrogen (H), carbon (C), or silicon (Si), and z may represent an atomic percentage greater than or equal to 40 at% and less than or equal to 85 at% (e.g., 40 at% ≤ z ≤ 85 at%). In some embodiments, the third molybdenum (Mo) derivative constituting the third conductive layer 146 may have lower surface energy than the second molybdenum (Mo) derivative constituting the second conductive layer 144, have lower surface energy than the first molybdenum (Mo) derivative constituting the first conductive layer 142, or have lower surface energy than the metal molybdenum (e.g., pure metal molybdenum that does not include an additive element or pure metal molybdenum into which an additive element is not intentionally doped or injected).

In some embodiments, the first additive element (e.g., M₁) included in the first conductive layer 142, the second additive element (e.g., M₂) included in the second conductive layer 144, and the third additive element (e.g., M₃) included in the third conductive layer 146 may be the same material or may be different materials.

In some embodiments, the first additive element included in the first conductive layer 142, the second additive element included in the second conductive layer 144, and the third additive element included in the third conductive layer 146 may all include nitrogen (N). In some embodiments, the first additive element included in the first conductive layer 142 and the second additive element included in the second conductive layer 144 may include nitrogen (N), and the third additive element included in the third conductive layer 146 may include oxygen (O). In some embodiments, the first additive element included in the first conductive layer 142 and the second additive element included in the second conductive layer 144 may include oxygen (O), and the third additive element included in the third conductive layer 146 may include nitrogen (N).

In some embodiments, the plurality of word lines WL may respectively include a plurality of main conductive regions MP surrounding upper surfaces, bottom surfaces, and sidewalls of the plurality of semiconductor patterns AP at positions vertically overlapping the plurality of semiconductor patterns AP. In addition, each of the plurality of word lines WLs may include a connection region CP disposed between two main conductive regions MP adjacent to each other in the second horizontal direction Y between two semiconductor patterns AP adjacent to each other in the second horizontal direction Y. The connection region CP may be integrally connected to the two main conductive regions MP. As shown in FIG. 6, an upper surface of the connection region CP may be at a lower vertical level than an upper surface of a part of the main conductive region MP disposed on an upper surface of the semiconductor pattern AP, and a bottom surface of the connection region CP may be at a lower vertical level than a bottom surface of a part of the main conductive region MP disposed on a bottom surface of the semiconductor pattern AP.

In some embodiments, as each of the plurality of word lines WL includes the word line conductive layer 140 including the first to third conductive layers 142 to 146, the word line conductive layer 140 disposed in the connection region CP may not include a void or a seam therein.

In some embodiments, a gate insulating layer GI may be disposed between the word line WL and the semiconductor pattern AP. The gate insulating layer GI may include at least one of a high-k dielectric material having a higher dielectric constant than that of silicon oxide (SiO₂) or a ferroelectric material. In some embodiments, the gate insulating layer GI may include at least one of hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxide nitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconium titanium oxide (PbZrTiO), strontium tantalum bismuth oxide (SrTaBiO), bismuth iron oxide (BiFeO), strontium titanium oxide (SrTiO), yttrium oxide (YO), aluminum oxide (AlO), or lead scandium tantalum oxide (PbScTaO).

Each semiconductor pattern AP may include a first end portion E1 adjacent to the bit line BL and a second end portion E2 disposed opposite the first end E1 and adjacent to the cell capacitor CAP. The second end portion E2 of each semiconductor pattern AP may be surrounded by a first gap-fill insulating layer 122 and a first insulating liner 124. As shown in FIG. 5, the first gap-fill insulating layer 122 may be disposed between the second end portions E2 of two semiconductor patterns AP adjacent to each other in the vertical direction Z, and the first insulating liner 124 may extend in the vertical direction Z on a first sidewall of the first gap-fill insulating layer 122. A second insulating liner 132 and a third insulating liner 134 may extend on the upper surface and the bottom surface of the semiconductor pattern AP on a second sidewall of the first gap-fill insulating layer 122. A part of a second gap-fill insulating layer 136 may be disposed at a position vertically overlapping the second insulating liner 132 and the third insulating liner 134, and the other part of the second gap-fill insulating layer 136 may be disposed between the plurality of word lines WLs. A spacer 138 may be disposed on a sidewall of the word line WL adjacent to the first end portion E1 of the semiconductor pattern AP, and the gate insulating layer GI may be disposed on an upper surface and a bottom surface of the spacer 138.

In some embodiments, each of the first gap-fill insulating layer 122, the second gap-fill insulating layer 136, the first insulating liner 124, the second insulating liner 132, the third insulating liner 134, and the spacer 138 may be formed using at least one of silicon oxide (SiO₂), silicon nitride (Si₃N₄), or silicon oxynitride (SiON).

In some embodiments, as shown in FIG. 8, the gate insulating layer GI may be disposed between the word line WL and the semiconductor pattern AP, and may be disposed between the word line WL and the second gap-fill insulating layer 136. For example, the second gap-fill insulating layer 136 may be disposed to be spaced apart from two semiconductor patterns AP disposed adjacent to each other in the vertical direction Z, the gate insulating layer GI and a first word line from among the word lines WL may be disposed between a first semiconductor pattern disposed at a higher level from among the two semiconductor patterns AP and the upper surface of the second gap-fill insulating layer 136, and the gate insulating layer GI and a second word line from among the word lines WL may be disposed between a second semiconductor pattern disposed at a lower level from among the two semiconductor patterns AP and the bottom surface of the second gap-fill insulating layer 136. The gate insulating layer GI may be disposed on an upper surface and a bottom surface of the first word line, and on an upper surface and a bottom surface of the second word line.

The first end portions E1 of the plurality of semiconductor patterns AP may be connected to the plurality of bit lines BL. The plurality of bit lines BL may extend in the vertical direction Z on the substrate 110 and may be spaced apart from each other in the second horizontal direction Y. The plurality of bit lines BL may include any one of a doped semiconductor material, a conductive metal nitride, a metal, or a metal-semiconductor compound. A first bit line isolation insulating layer BIL1 extending in the vertical direction Z may be disposed between two bit lines BL adjacent to each other in the second horizontal direction Y. A second bit line isolation insulating layer BIL2 may be disposed between the plurality of bit lines BL and the substrate 110. The spacer 138 may be disposed between the sidewall of the bit line BL and the word line WL so that the word line WL may be electrically insulated from the bit line BL.

In some embodiments, as shown in FIG. 4, one bit line BL may be disposed between one semiconductor pattern AP and the other semiconductor pattern AP disposed to be spaced apart from one semiconductor pattern AP in the first horizontal direction X, and the two transistors constituted by the two semiconductor patterns AP may share one bit line BL.

In some embodiments, an ohmic metal layer including metal silicide may be further formed between the first end portion E1 of the semiconductor pattern AP and the bit line BL.

In some embodiments, the cell capacitor CAP may include a first electrode EL1, a capacitor dielectric layer DL, and a second electrode EL2.

In some embodiments, the first electrode EL1 may be disposed to be connected to the second end portion E2 of the semiconductor pattern AP, and the first electrode EL1 may have a bar shape or a pillar shape extending in the first horizontal direction X.

In some embodiments, the capacitor dielectric layer DL may be disposed on the first electrode EL1, and may be conformally disposed on, for example, an upper surface, a bottom surface, and a sidewall of the first electrode EL1.

In some embodiments, the second electrode EL2 may be disposed on the capacitor dielectric layer DL, and may be conformally disposed on an upper surface, a bottom surface, and a sidewall of the capacitor dielectric layer DL. For example, the capacitor dielectric layer DL may be disposed between the first electrode EL1 and the second electrode EL2.

In some embodiments, the first electrode EL1 and the second electrode EL2 may each include a doped semiconductor material, a conductive metal nitride such as, but not limited to, titanium nitride (TiN), tantalum nitride (TaN), niobium nitride (NbN), or tungsten nitride (WN), a metal including at least one of ruthenium (Ru), iridium (Ir), titanium (Ti), or tantalum (Ta), an iridium oxide (IrO₂), or a conductive metal oxide such as, but not limited to, niobium oxide (Nb₂O₅). In some embodiments, the capacitor dielectric layer DL may include at least one of a high-k dielectric material having a higher dielectric constant than that of silicon oxide (SiO₂) and a ferroelectric material. In some embodiments, the gate insulating layer GI may include at least one of hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxide nitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconium titanium oxide (PbZrTiO), strontium tantalum bismuth oxide (SrTaBiO), bismuth iron oxide (BiFeO), strontium titanium oxide (SrTiO), yttrium oxide (YO), aluminum oxide (AlO), or lead scandium tantalum oxide (PbScTaO).

A plate electrode PP may be disposed to extend in the vertical direction Z and the second horizontal direction Y on one side of the cell capacitor CAP. The second electrode EL2 of the cell capacitor CAP may be electrically connected to the plate electrode PP.

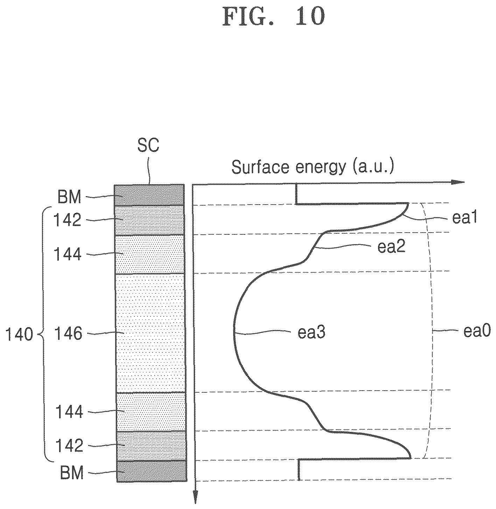

Hereinafter, surface energy characteristics of the word line WL are described with reference to FIG. 10.

FIG. 10 is a graph schematically illustrating surface energy of the word line WL, according to some embodiments. FIG. 10 illustrates the surface energy according to a position of the word line WL corresponding to a scan portion SC of FIG. 7 along a Y-axis.

Referring to FIG. 10, the word line WL may include the barrier metal layer BM and the word line conductive layer 140. The word line conductive layer 140 may include a molybdenum (Mo)-based metal derivative, and may include the first conductive layer 142, the second conductive layer 144, and the third conductive layer 146 sequentially disposed on the barrier metal layer BM.

In some embodiments, the first conductive layer 142 may be represented as a chemical formula similar to MoM₁ₓ, where M₁ may include at least one of oxygen (O), chlorine (CI), nitrogen (N), hydrogen (H), carbon (C), or silicon (Si), and x may represent an atomic percentage greater than or equal to 0.01 at% and less than or equal to 20 at% (e.g., 0.01 at% ≤ x ≤ 20 at%). The second conductive layer 144 may be represented as a chemical formula similar to MoM_{2y}, where M₂ may include at least one of oxygen (O), chlorine (CI), nitrogen (N), hydrogen (H), carbon (C), or silicon (Si), and y may represent an atomic percentage greater than or equal to 15 at% and less than or equal to 40 at% (e.g., 15 at% ≤ y ≤ 40 at%). The third conductive layer 146 may be represented as a chemical formula similar to MoM_{3z}, where M₃ may include at least one of oxygen (O), chlorine (CI), nitrogen (N), hydrogen (H), carbon (C), or silicon (Si), and z may represent an atomic percentage greater than or equal to 40 at% and less than or equal to 80 at% (e.g., 40 at% ≤ z ≤ 85 at%).

In some embodiments, the first conductive layer 142 may have first surface energy ea1. The second conductive layer 144 may have second surface energy ea2, and the second surface energy ea2 may be less than the first surface energy ea1. The third conductive layer 146 may have third surface energy ea3, and the third surface energy ea3 may be less than the second surface energy ea2 and/or the first surface energy ea1.

In FIG. 10, surface energy ea0 of the word line conductive layer including metal molybdenum is indicated by a dashed line for comparison. The surface energy ea0 of the word line conductive layer including metal molybdenum may have a value greater than those of the first to third surface energies ea1 to ea3. In a case of a comparative example in which the word line conductive layer includes a single layer of metal molybdenum, a relatively high metal-metal interaction may be exerted by the relatively large surface energy ea0 of metal molybdenum so that a semiconductor pattern may be bending or leaning, and a void or a seam may remain inside the word line conductive layer (especially in a connection portion of the word line conductive layer).

However, according to some embodiments, a composition or an impurity level of additive elements included in the first to third conductive layers 142 to 146 may increase sequentially and/or gradually, and accordingly, the first to third conductive layers 142 to 146 may have surface energy that decreases sequentially and/or gradually. Accordingly, the semiconductor pattern may be prevented from bending and/or leaning in the process of forming the word line conductive layer 140, and/or defects in which a void or a seam is formed inside the word line conductive layer 140 (e.g., in the connection region CP of the word line WL) may be prevented.

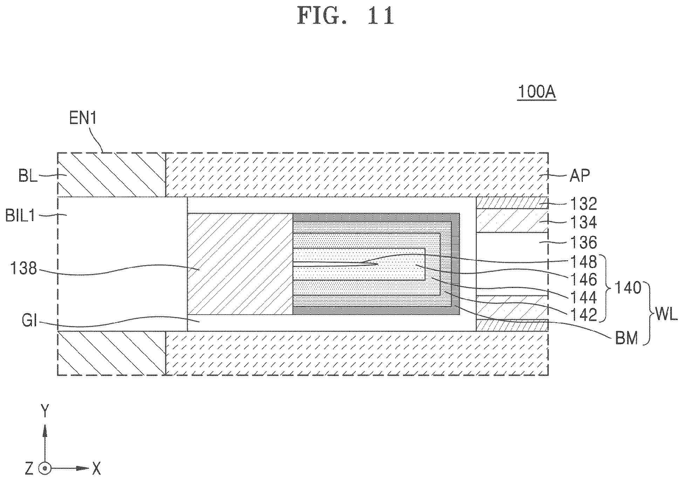

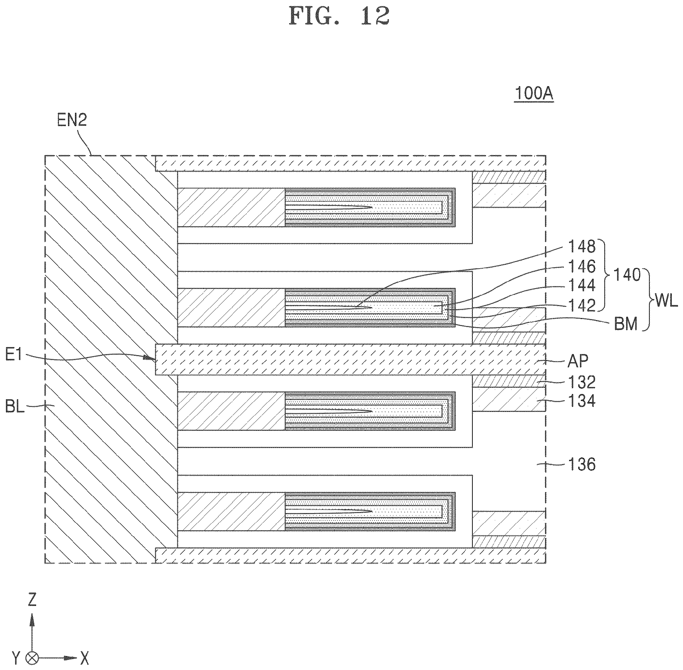

FIGS. 11 and 12 are schematic diagrams illustrating a semiconductor memory device 100A, according to some embodiments. FIG. 11 is an enlarged view corresponding to the portion EN1 of FIG. 4, and FIG. 12 is an enlarged view corresponding to the portion EN2 of FIG. 5.

Referring to FIGS. 11 and 12, the word line conductive layer 140 may include the first conductive layer 142, the second conductive layer 144, the third conductive layer 146, and a surface treatment layer 148. In some embodiments, the first conductive layer 142, the second conductive layer 144, and the third conductive layer 146 may have technical characteristics similar to those described with reference to FIGS. 1 to 9.

In some embodiments, the surface treatment layer 148 may include a material layer formed by performing surface treatment on a surface of the third conductive layer 146. In some embodiments, the surface treatment may be a nitridation treatment. In some embodiments, the surface treatment may be an annealing treatment using silane gas. However, embodiments of the present disclosure are not limited in this regard. For example, the surface treatment layer 148 may include a nitride or silicide material of a third molybdenum (Mo) derivative constituting the third conductive layer 146.

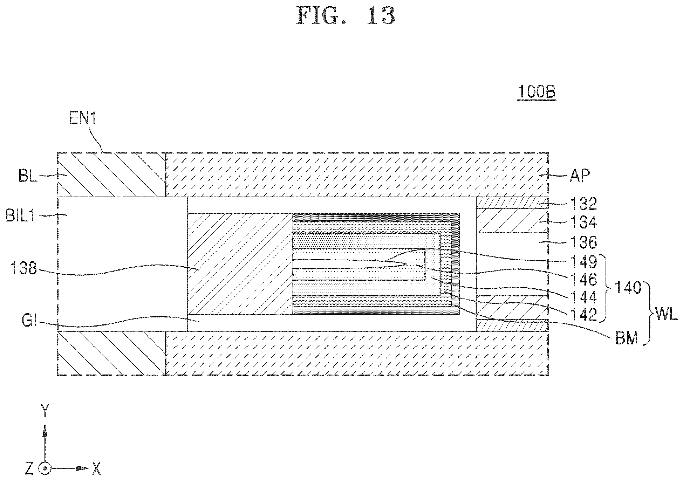

FIG. 13 is a schematic diagram illustrating a semiconductor memory device 100B, according to some embodiments. FIG. 13 is an enlarged view corresponding to the portion EN1 of FIG. 4.

Referring to FIG. 13, the word line conductive layer 140 may include the first conductive layer 142, the second conductive layer 144, the third conductive layer 146, and a fourth conductive layer 149. In some embodiments, the first conductive layer 142, the second conductive layer 144, and the third conductive layer 146 may have technical characteristics similar to those described with reference to FIGS. 1 to 9.

In some embodiments, the fourth conductive layer 149 may be formed by removing a partial thickness of the third conductive layer 146 through a self-limited etching process on a surface of the third conductive layer 146 and filling a space from which a part of the third conductive layer 146 is removed with a metal material, a metal nitride, or a metal silicon nitride. In some embodiments, the fourth conductive layer 149 may include a material having a lower surface energy than that of metal molybdenum. In some embodiments, the fourth conductive layer 149 may include at least one of titanium nitride (TiN), titanium silicon nitride (TiSiN), molybdenum silicon nitride (MoSiN), or molybdenum silicon nitride hydride (MoSiNH).

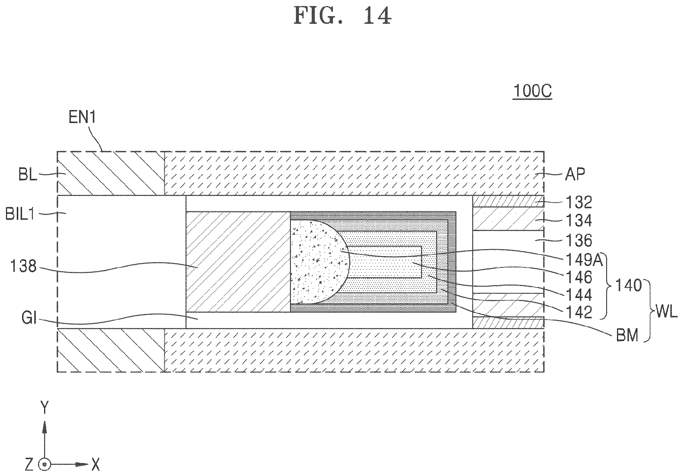

FIG. 14 is a schematic diagram illustrating a semiconductor memory device 100C, according to some embodiments. FIG. 14 is an enlarged view corresponding to the portion EN1 of FIG. 4.

Referring to FIG. 14, the word line conductive layer 140 may include the first conductive layer 142, the second conductive layer 144, the third conductive layer 146, and a fourth conductive layer 149A. In some embodiments, the first conductive layer 142, the second conductive layer 144, and the third conductive layer 146 may have technical characteristics similar to those described with reference to FIGS. 1 to 9.

In some embodiments, after forming the first conductive layer 142, the second conductive layer 144, and the third conductive layer 146, parts of the first conductive layer 142, the second conductive layer 144, and the third conductive layer 146 may be removed by an etch-back process, and the fourth conductive layer 149A may be formed by filling a metal material, a metal nitride, or a metal silicon nitride in an etch-back space. In some embodiments, the fourth conductive layer 149A may include a material having a lower surface energy than that of metal molybdenum. In some embodiments, the fourth conductive layer 149A may include at least one of titanium nitride (TiN), titanium silicon nitride (TiSiN), molybdenum silicon nitride (MoSiN), or molybdenum silicon nitride hydride (MoSiNH).

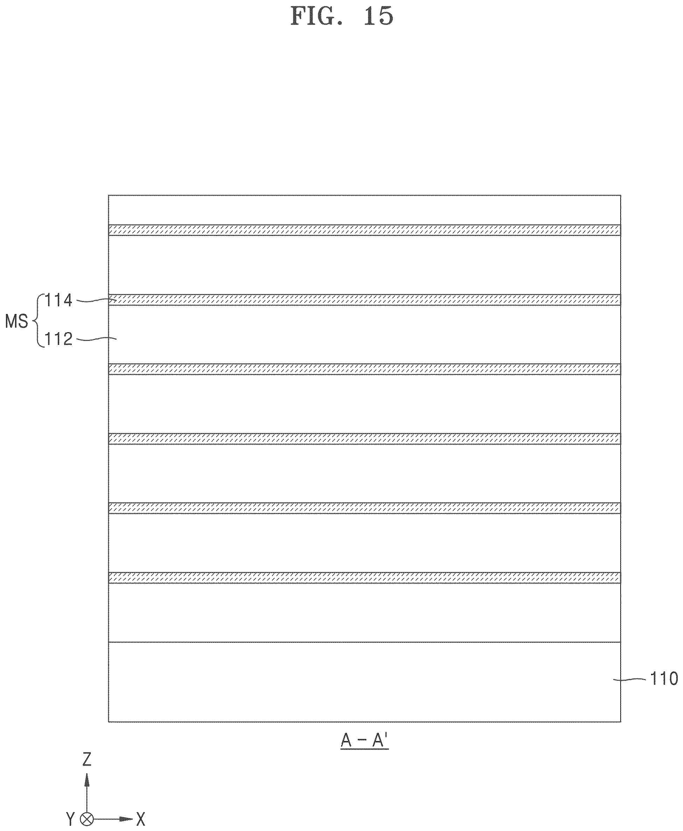

FIGS. 15 to 31 are schematic diagrams illustrating a method of manufacturing the semiconductor memory device 100.

Referring to FIG. 15, a mold stack MS may be formed by alternately and sequentially forming a sacrificial mold layer 112 and a semiconductor layer 114 on the substrate 110.

In some embodiments, the sacrificial mold layer 112 and the semiconductor layer 114 may include materials having etch selectivity with respect to each other. For example, the sacrificial mold layer 112 and the semiconductor layer 114 may each include a single crystal layer of a group IV semiconductor, a group IV-IV compound semiconductor, or a group III-V compound semiconductor, and the sacrificial mold layer 112 and the semiconductor layer 114 may include different materials. In an example, the sacrificial mold layer 112 may include silicon-germanium (SiGe), and the semiconductor layer 114 may include single crystal silicon. Each of the sacrificial mold layer 112 and the semiconductor layer 114 may have a thickness of several tens of nanometers (nm) (e.g., 20 nm to 90 nm).

In some embodiments, the sacrificial mold layer 112 and the semiconductor layer 114 may be formed by an epitaxy process. For example, the epitaxy process may be a chemical vapor deposition (CVD) process such as, but not limited to, vapor-phase epitaxy (VPE), ultra-high vacuum CVD (UHV-CVD), molecular beam epitaxy (molecular beam epitaxy), or a combination thereof. In the epitaxy process, a liquid or gaseous precursor may be used as a precursor required to form the sacrificial mold layer 112 and the semiconductor layer 114.

In some embodiments, as shown in FIG. 15, the thickness of the semiconductor layer 114 in the vertical direction Z may be less than the thickness of the sacrificial mold layer 112 in the vertical direction Z. In some embodiments, the thickness of the semiconductor layer 114 in the vertical direction Z may be substantially similar and/or the same as the height of the semiconductor pattern AP to be formed in a subsequent process.

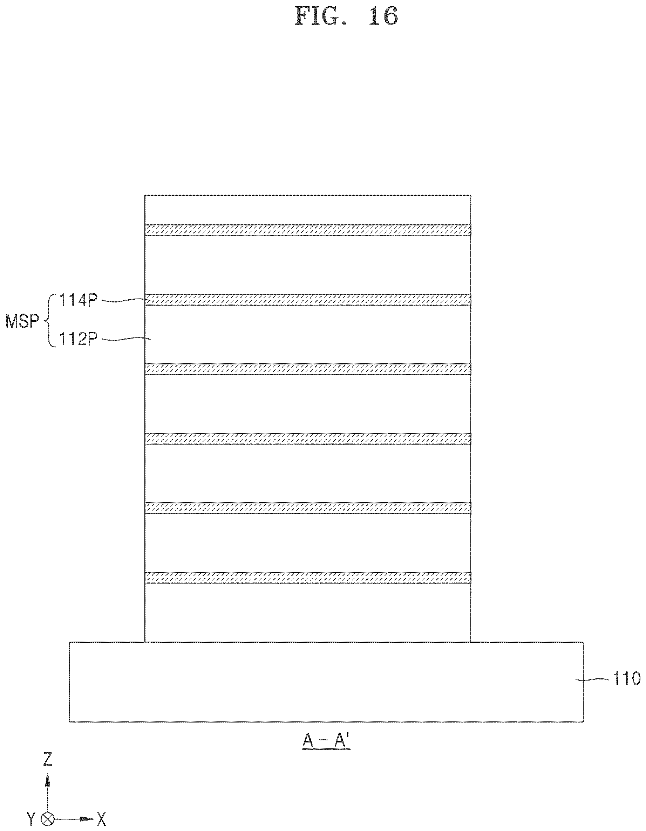

Referring to FIG. 16, a mold stack pattern MSP including a plurality of semiconductor layer patterns 114P and a plurality of sacrificial mold layer patterns 112P alternately stacked may be formed by forming a mask pattern on the mold stack MS, and removing a part of the mold stack MS by using the mask pattern as an etching mask. The plurality of semiconductor layer patterns 114P and the plurality of sacrificial mold layer patterns 112P may be disposed at positions overlapping each other in the vertical direction Z and may extend in the first horizontal direction X.

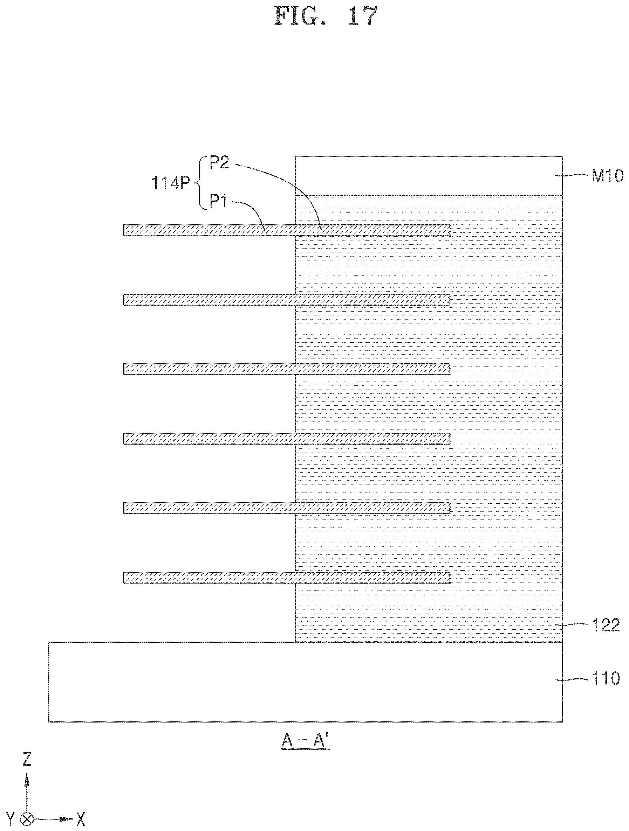

Referring to FIG. 17, the first gap-fill insulating layer 122 may be formed by removing the plurality of sacrificial mold layer patterns 112P, and using an insulating material at positions where the sacrificial mold layer patterns 112P are removed.

In some embodiments, a process of removing the plurality of sacrificial mold layer patterns 112P may be and/or may include at least one of a wet etching process or a pull-back process. However, embodiments of the present disclosure are not limited in this regard. For example, the process of removing the plurality of sacrificial mold layer patterns 112P may be an etching process using etching selectivity between the sacrificial mold layer patterns 112P and the plurality of semiconductor layer patterns 114P. As another example, in the wet etching process and/or the pull-back process, the etching rate of the plurality of semiconductor layer patterns 114P may be relatively low and the etching rate of the plurality of sacrificial mold layer patterns 112P may be relatively high.

Thereafter, a first mask pattern M10 may be formed on the first gap-fill insulating layer 122. Each of the plurality of semiconductor layer patterns 114P may include a first portion P1 and a second portion P2, and the first mask pattern M10 may be disposed to vertically overlap the second portions P2 of the plurality of semiconductor layer patterns 114P.

Thereafter, the first portions P1 of the plurality of semiconductor layer patterns 114P may be exposed by removing a part of the first gap-fill insulating layer 122 not covered by the first mask pattern M10. The second portions P2 of the plurality of semiconductor layer patterns 114P may be covered by the first gap-fill insulating layer 122 and may not be exposed to the outside. In some embodiments, a process of removing a part of the first gap-fill insulating layer 122 may include a lateral recess process or a pull-back process.

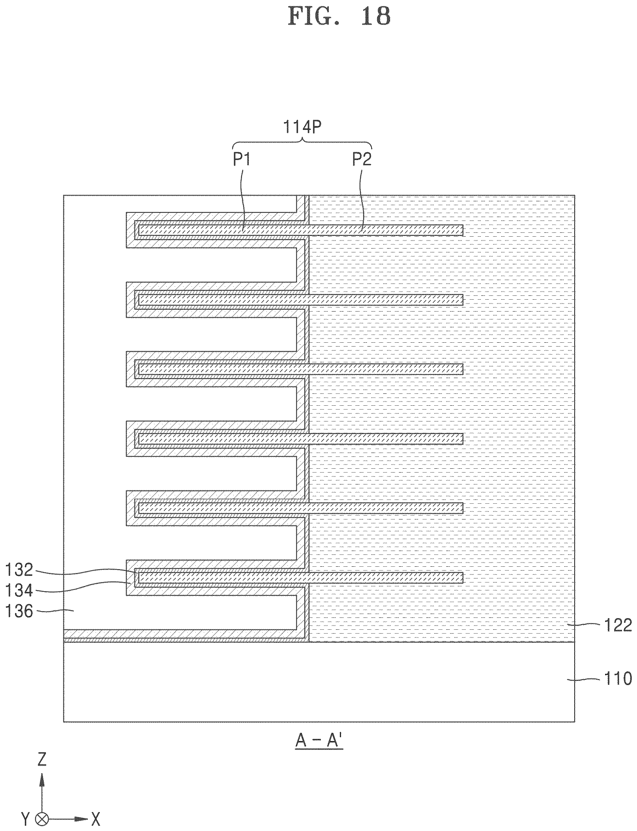

Referring to FIG. 18, a second insulating liner 132, a third insulating liner 134, and a second gap-fill insulating layer 136 may be sequentially formed on upper surfaces, bottom surfaces, and sidewalls of the first portions P1 of the plurality of semiconductor layer patterns 114P. In some embodiments, the second insulating liner 132, the third insulating liner 134, and the second gap-fill insulating layer 136 may each be formed using at least one of silicon oxide (SiO₂), silicon nitride (Si₃N₄), or silicon oxynitride (SiON). In some embodiments, the second insulating liner 132 and the second gap-fill insulating layer 136 may each include silicon oxide (SiO₂) and the third insulating liner 134 may include silicon nitride (Si₃N₄).

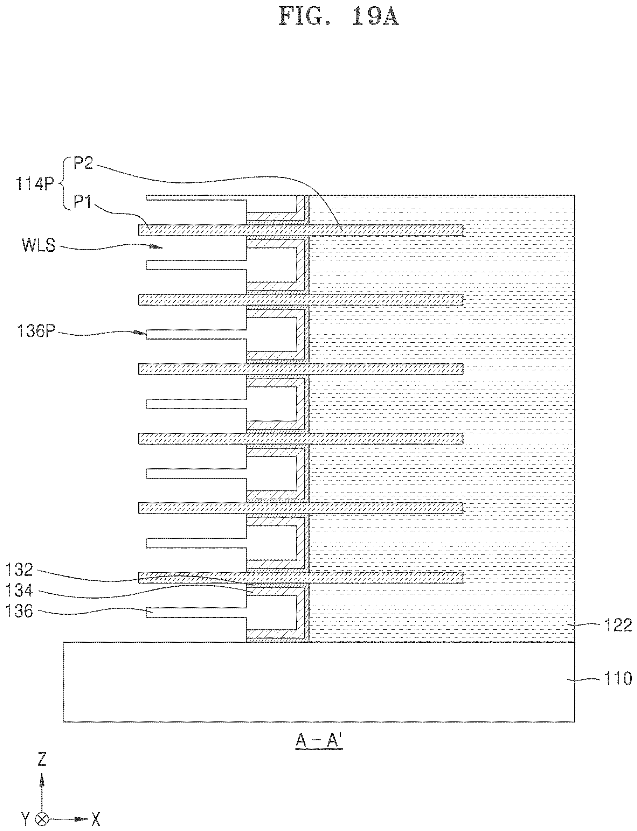

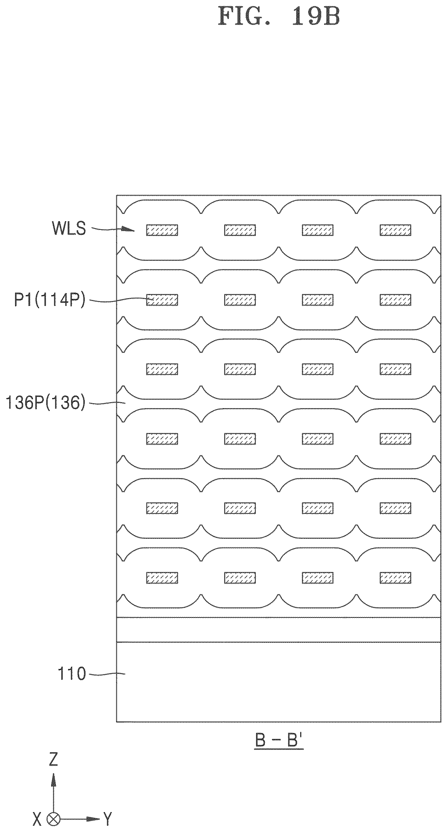

Referring to FIGS. 19A and 19B, a sidewall of the second insulating liner 132 may be exposed by removing a part of the second gap-fill insulating layer 136, and the second insulating liner 132 and the third insulating liner 134 may be removed by a certain length in a lateral direction. Accordingly, a part of the first portion P1 of the semiconductor layer pattern 114P may be exposed again. A protrusion portion 136P of the second gap-fill insulating layer 136 may be disposed between two first portions P1 adjacent to each other in the vertical direction Z, and a word line space WLS may be formed between the protrusion portion 136P and the first portion P1.

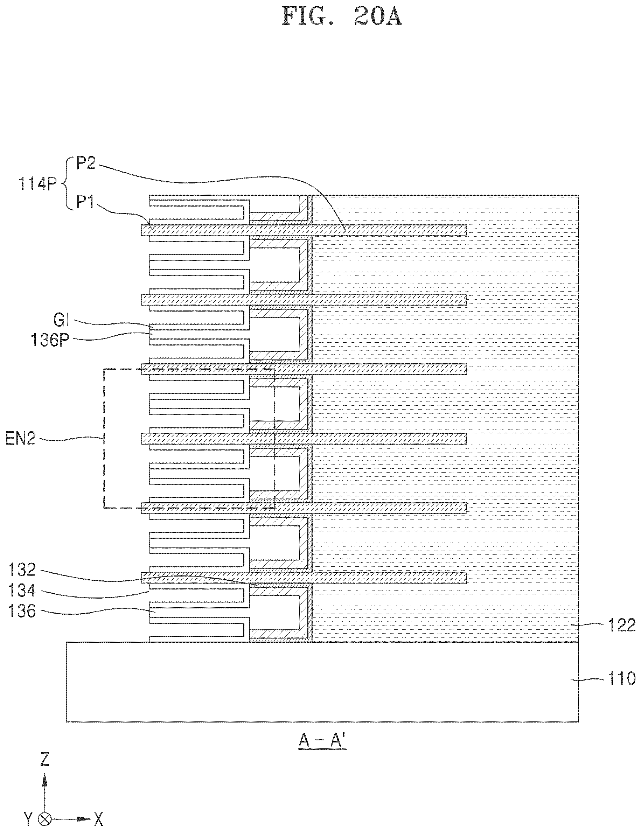

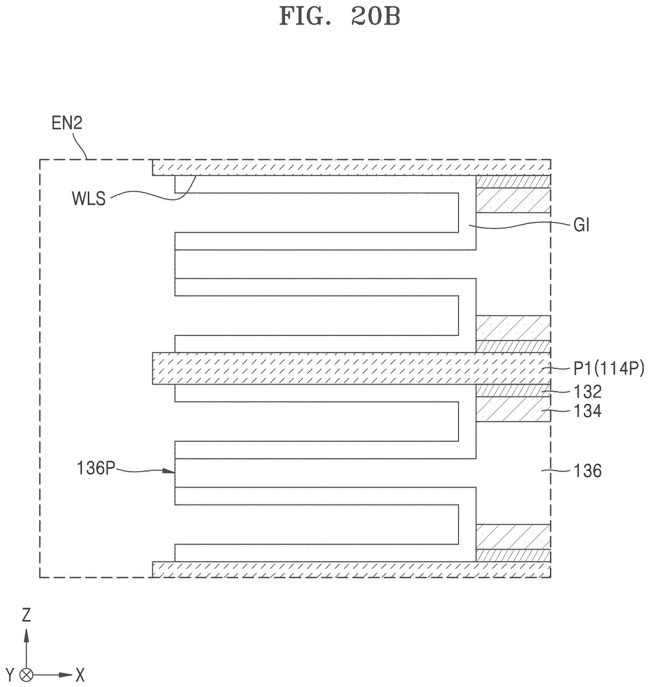

Referring to FIGS. 20A and 20B, the gate insulating layer GI may be formed in a space defined between the first portion P1 of the semiconductor layer pattern 114P and the protrusion portion 136P of the second gap-fill insulating layer 136, that is, on an inner wall of the word line space WLS. In some embodiments, a part of the gate insulating layer GI disposed on a sidewall of the first portion P1 of the semiconductor layer pattern 114P may be removed by an etching process, and the sidewall of the first portion P1 may be exposed again.

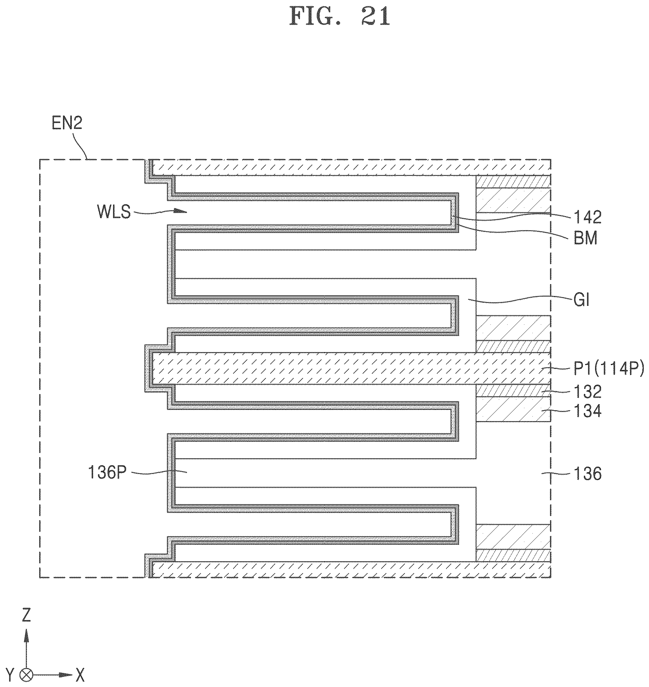

Referring to FIG. 21, the barrier metal layer BM and the first conductive layer 142 may be sequentially formed on the inner wall of the word line space WLS. The barrier metal layer BM and the first conductive layer 142 may be conformally formed on the surface of the gate insulating layer GI disposed inside the word line space WLS.

In some embodiments, the barrier metal layer BM may include at least one of titanium (Ti), titanium nitride (TiN), titanium aluminum carbide (TiAIC), titanium aluminum nitride (TiAIN), titanium silicon nitride (TiSiN), molybdenum silicon nitride (MoSiN), tungsten nitride (WN), tungsten silicon nitride (WSiN), tantalum (Ta), tantalum silicon nitride (TaSiN), tantalum nitride (TaN), or lanthanum nitride (LaN). In some embodiments, the barrier metal layer BM may be omitted.

In some embodiments, the first conductive layer 142 may include a first molybdenum (Mo) derivative. In some embodiments, the first conductive layer 142 may be formed by a chemical vapor deposition process, an atomic layer lamination process, or the like. In some embodiments, the first molybdenum (Mo) derivative may include metal molybdenum as a main component, but may include a first additive element of at least one of oxygen (O), chlorine (CI), nitrogen (N), hydrogen (H), carbon (C), or silicon (Si) in a first content. In some embodiments, the first content of the first additive element may have a range from 0.01 at% to 20 at%.

In some embodiments, the first molybdenum (Mo) derivative may be represented as a chemical formula similar to MoM₁ₓ, where M₁ may include at least one of oxygen (O), chlorine (CI), nitrogen (N), hydrogen (H), carbon (C), or silicon (Si), and x may represent an atomic percentage greater than or equal to 0.01 at% and less than or equal to 20 at% (e.g., 0.01 at% ≤ x ≤ 20 at%). In some embodiments, the first molybdenum (Mo) derivative constituting the first conductive layer 142 may have a lower surface energy than metal molybdenum (e.g., pure metal molybdenum that does not include an additive element or pure metal molybdenum into which an additive element is not intentionally doped or injected).

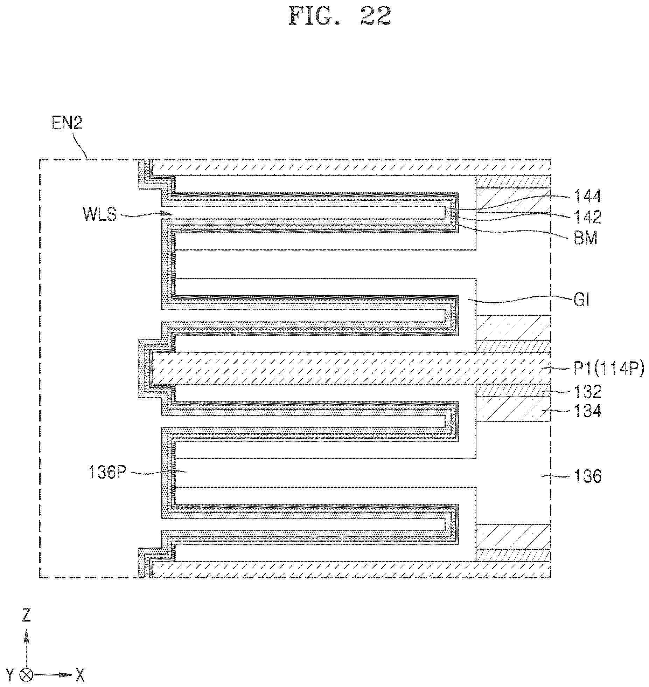

Referring to FIG. 22, the second conductive layer 144 may be formed on the inner wall of the word line space WLS. The second conductive layer 144 may be conformally formed on the surface of the first conductive layer 142 disposed inside the word line space WLS.

In some embodiments, the second conductive layer 144 may include a second molybdenum (Mo) derivative. In some embodiments, the second conductive layer 144 may be formed by a chemical vapor deposition process, an atomic layer lamination process, or the like. In some embodiments, the second molybdenum (Mo) derivative may include metal molybdenum as a main component, but may include a second additive element of at least one of oxygen (O), chlorine (CI), nitrogen (N), hydrogen (H), carbon (C), or silicon (Si) in a second content. In some embodiments, the second content of the second additive element may have a range from 15 at% to 40 at%.

In some embodiments, the second molybdenum (Mo) derivative may be represented as a chemical formula similar to MoM_{3z}, wherein M₂ may include at least one of oxygen (O), chlorine (CI), nitrogen (N), hydrogen (H), carbon (C), or silicon (Si), and y may represent an atomic percentage greater than or equal to 15 at% and less than or equal to 40 at% (e.g., 15 at% ≤ y ≤ 40 at%). In some embodiments, the second molybdenum (Mo) derivative constituting the second conductive layer 144 may have a lower surface energy than the first molybdenum (Mo) derivative constituting the first conductive layer 142, or may have a lower surface energy than metal molybdenum (e.g., pure metal molybdenum that does not include an additive element or pure metal molybdenum into which an additive element is not intentionally doped or injected).

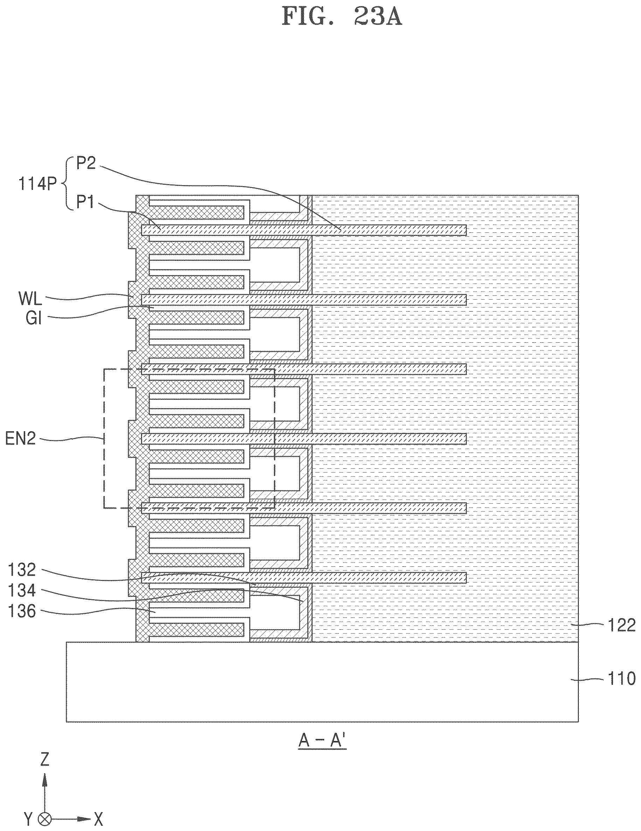

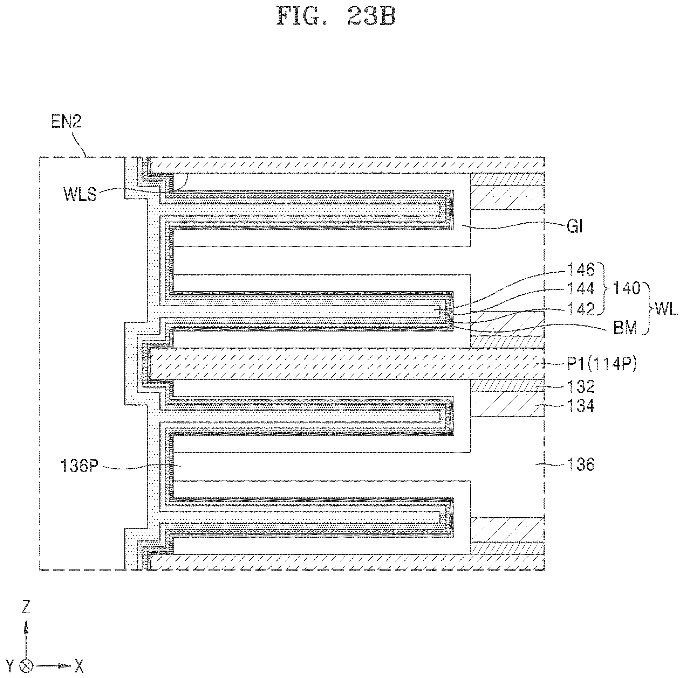

Referring to FIGS. 23A and 23B, the third conductive layer 146 may be formed on the inner wall of the word line space WLS. The third conductive layer 146 may be formed on the surface of the second conductive layer 144 disposed inside the word line space WLS, and may fill a residual portion of the word line space WLS.

In some embodiments, the third conductive layer 146 may include a third molybdenum (Mo) derivative. In some embodiments, the third conductive layer 146 may be formed by a chemical vapor deposition process, an atomic layer lamination process, or the like. In some embodiments, the third molybdenum (Mo) derivative may include metal molybdenum as a main component, but may include a third additive element of at least one of oxygen (O), chlorine (CI), nitrogen (N), hydrogen (H), carbon (C), or silicon (Si) in a third content. In some embodiments, the third content of the third additive element may have a range from 40 at% to 85 at%.

In some embodiments, the third molybdenum (Mo) derivative may be represented as a chemical formula similar to MoM_{3z}, where M₃ may include at least one of oxygen (O), chlorine (CI), nitrogen (N), hydrogen (H), carbon (C), or silicon (Si), and z may represent an atomic percentage greater than or equal to 40 at% and less than or equal to 85 at% (e.g., 40 at% ≤ z ≤ 85 at%). In some embodiments, the third molybdenum (Mo) derivative constituting the third conductive layer 146 may have a lower surface energy than the second molybdenum (Mo) derivative constituting the second conductive layer 144, have a lower surface energy than the first molybdenum (Mo) derivative constituting the first conductive layer 142, or have a lower surface energy than the metal molybdenum (e.g., pure metal molybdenum that does not include an additive element or pure metal molybdenum into which an additive element is not intentionally doped or injected).

As used herein, the first conductive layer 142, the second conductive layer 144, and the third conductive layer 146 may be referred to as the word line conductive layer 140. In addition, the barrier metal layer BM and the word line conductive layer 140 may collectively be referred to as the word line WL. The word line conductive layer 140 may have a surface energy that sequentially and/or gradually decreases in a thickness direction thereof (e.g., in the order of the first conductive layer 142, the second conductive layer 144, and the third conductive layer 146), and accordingly, bending or leaning of the first portion P1 of the semiconductor layer pattern 114P may not occur and/or may be reduced. In addition, as bending and/or leaning of the first portion P1 of the semiconductor layer pattern 114P may be reduced and/or prevented, a void and/or a seam may be prevented from being formed in the word line space WLS in a process of forming the word line conductive layer 140 in the word line space WLS.

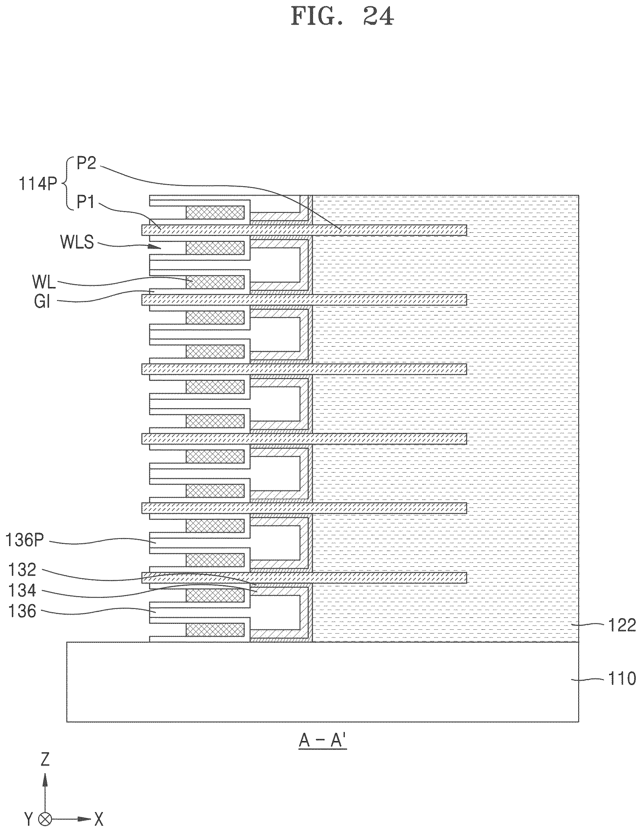

Referring to FIG. 24, the word line WL may remain inside the word line space WLS by removing a part of the word line WL from the entrance of the word line space WLS. A process of removing a part of the word line WL may include a lateral recess process or a pull-back process. In some embodiments, as the word line WL remains inside the word line space WLS, a sidewall of the first portion P1 of the semiconductor layer pattern 114P covered by the word line WL and a sidewall of the protrusion portion 136P of the second gap-fill insulating layer 136 may be exposed again.

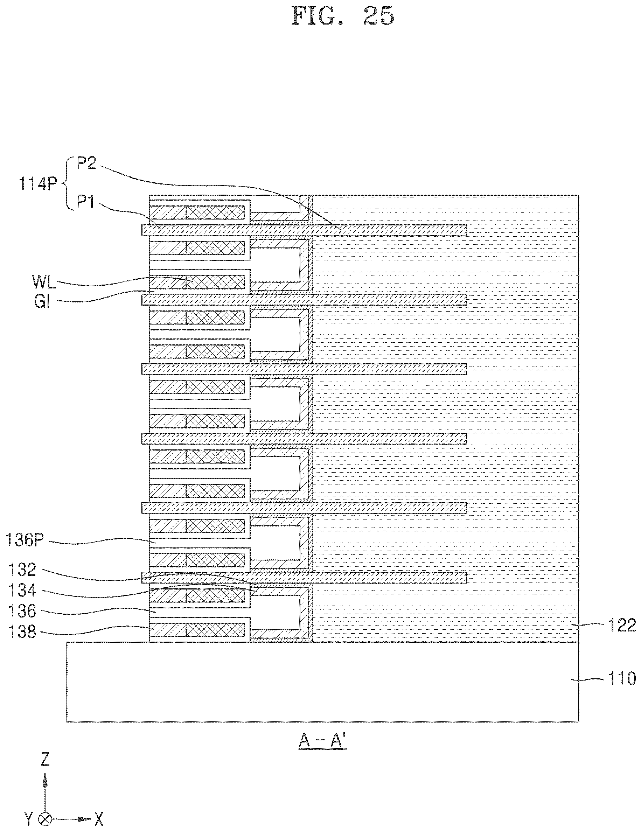

Referring to FIG. 25, the spacer 138 filling a residual portion of the word line space WLS may be formed. In some embodiments, the spacer 138 may be formed using at least one of silicon oxide (SiO₂), silicon nitride (Si₃N₄), or silicon oxynitride (SiON).

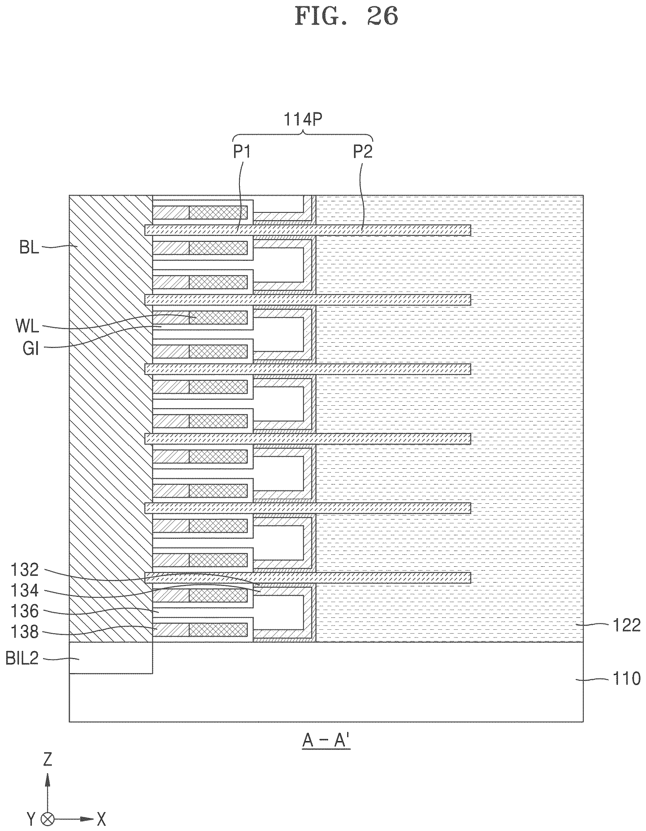

Referring to FIG. 26, the bit line BL connected to the first portion P1 of the semiconductor layer pattern 114P and extending in the vertical direction Z may be formed. In some embodiments, before forming the bit line BL, a recess region may be formed by removing a part of the substrate 110, and the second bit line isolation insulating layer BIL2 may be formed in the recess region. In addition, a first bit line isolation insulating layer BIL1 (see FIG. 4) filling a space between two adjacent bit lines BL and extending in the vertical direction Z may be further formed before or after the bit line BL is formed.

In some embodiments, the bit line BL may be formed to be in contact with a sidewall of the first portion P1 of the semiconductor layer pattern 114P. In some embodiments, the sidewall of the first portion P1 of the semiconductor layer pattern 114P may protrude outward (e.g., toward the bit line BL) with respect to the sidewall of the gate insulating layer GI and/or the sidewall of the spacer 138, and accordingly, the sidewall of the bit line BL may be recessed inward at a position corresponding to the first portion P1 of the semiconductor layer pattern 114P.

In some embodiments, the sidewall of the first portion P1 of the semiconductor layer pattern 114P may be aligned with the sidewall of the gate insulating layer GI and/or the sidewall of the spacer 138, and accordingly, the sidewall of the bit line BL may extend substantially vertically.

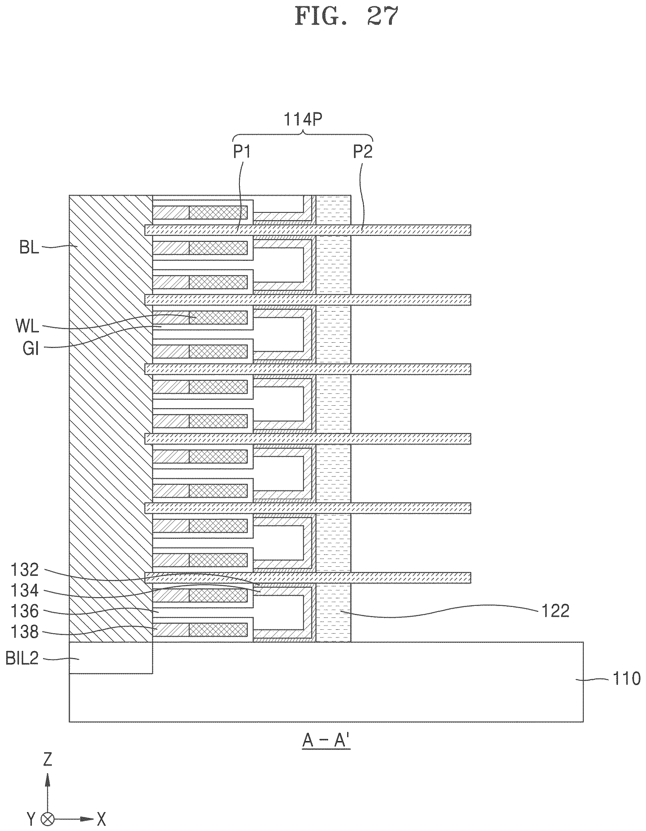

Referring to FIG. 27, a part of the second portions P2 of the plurality of semiconductor layer patterns 114P may be exposed by forming a mask pattern on the first gap-fill insulating layer 122 and removing a part of the first gap-fill insulating layer 122 by using the mask pattern as an etching mask. In some embodiments, a process of removing a part of the first gap-fill insulating layer 122 may include a lateral recess process or a pull-back process.

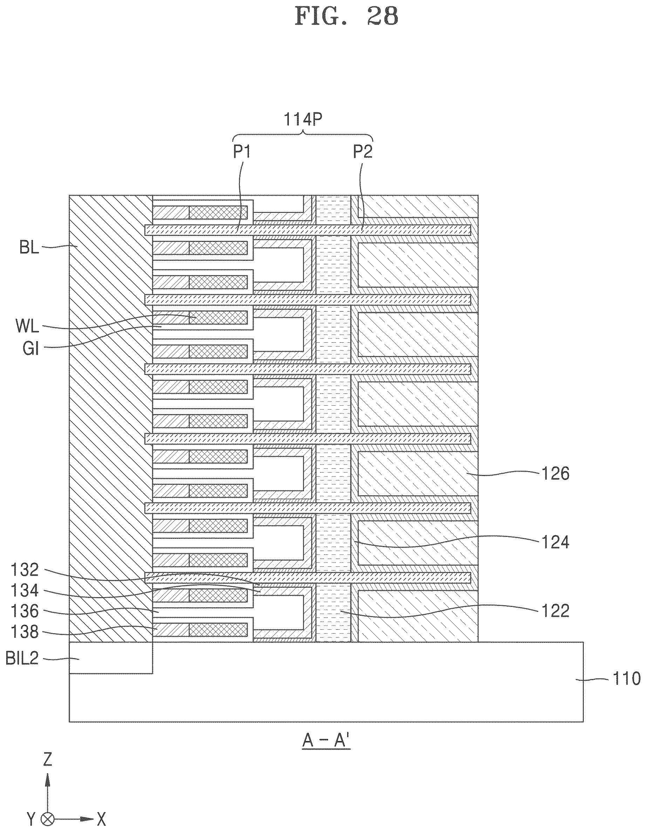

Referring to FIG. 28, the first insulating liner 124 and a third gap-fill insulating layer 126 may be sequentially formed on the second portions P2 of the plurality of semiconductor layer patterns 114P. The first insulating liner 124 may be conformally disposed on a sidewall of the first gap-fill insulating layer 122 and exposed surfaces of the second portions P2 of the plurality of semiconductor layer patterns 114P, and the third gap-fill insulating layer 126 may surround the second portions P2 of the plurality of semiconductor layer patterns 114P on the first insulating liner 124.

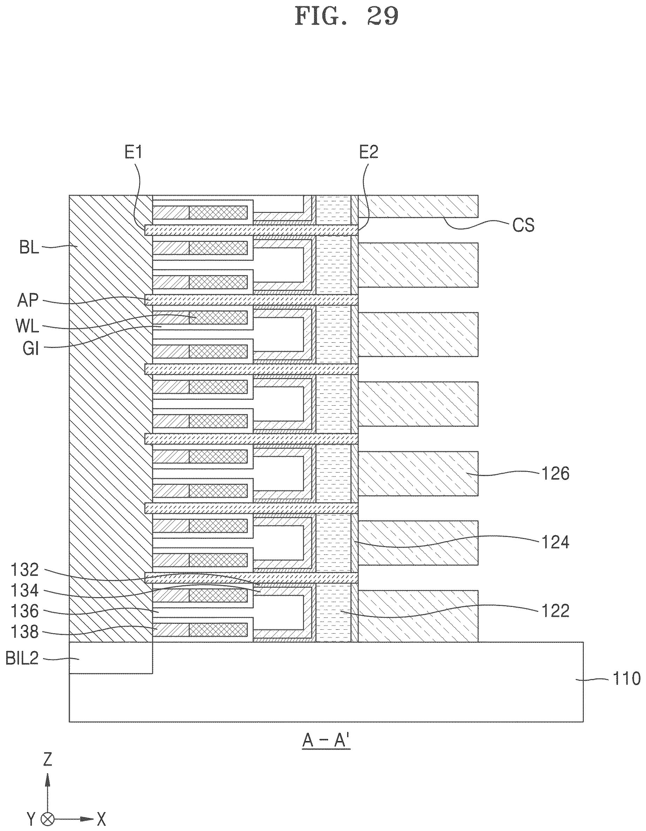

Referring to FIG. 29, a plurality of capacitor spaces CS may be formed by removing the second portions P2 of the plurality of semiconductor layer patterns 114P, and then removing a part of the first insulating liner 124. In some embodiments, the plurality of capacitor spaces CS may be disposed at positions respectively corresponding to the plurality of semiconductor layer patterns 114P, and may be, for example, spaced apart from each other in the vertical direction Z and the second horizontal direction Y.

As used herein, the plurality of semiconductor layer patterns 114P remaining by removing the second portions P2 of the plurality of semiconductor layer patterns 114P may be referred to as the semiconductor patterns AP. The second end portion E2 of the semiconductor pattern AP may be exposed to the capacitor space CS.

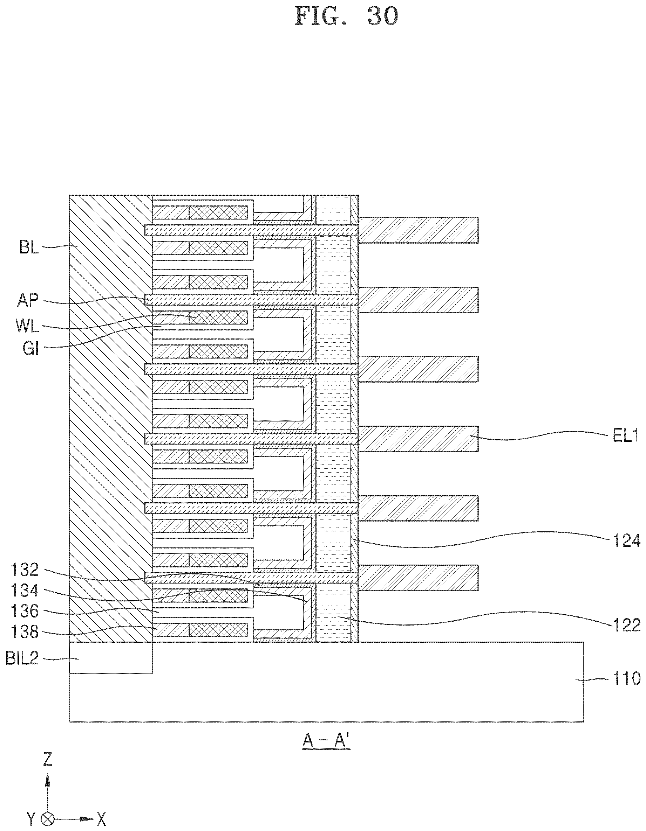

Referring to FIG. 30, the first electrode EL1 may be formed in the plurality of capacitor spaces CS. The first electrode EL1 may fill the inside of the plurality of capacitor spaces CS and may extend in the first horizontal direction X.

Thereafter, the third gap-fill insulating layer 126 may be removed.

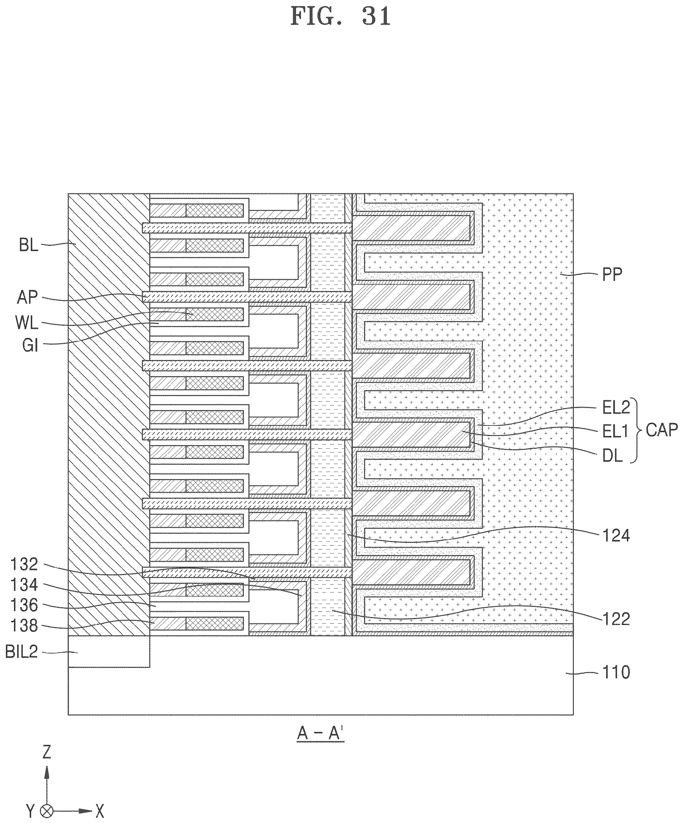

Referring to FIG. 31, the cell capacitor CAP may be formed by sequentially forming a capacitor dielectric layer DL and a second electrode EL2 on a surface of the first electrode EL1.

In some embodiments, the capacitor dielectric layer DL may be disposed on the first electrode EL1, and, for example, may be conformally disposed on an upper surface, a bottom surface, and a sidewall of the first electrode EL1. The second electrode EL2 may be disposed on the capacitor dielectric layer DL, and may be conformally disposed on an upper surface, a bottom surface, and a sidewall of the capacitor dielectric layer DL.

Thereafter, the plate electrode PP may be formed on the cell capacitor CAP (e.g., on the surface of the second electrode EL2). In some embodiments, at least a part of the plate electrode PP may be filled in a space between two adjacent cell capacitors CAP (e.g., in a space between two cell capacitors CAP adjacent in the second horizontal direction Y and/or in a space between two cell capacitors CAP adjacent in the vertical direction Z), as shown in FIG. 30.

According to the method of manufacturing the semiconductor memory device 100, according to the above-described embodiments, the word line conductive layer 140 may include the first to third conductive layers 142 to 146 each including a molybdenum (Mo) derivative, having an impurity level in the molybdenum (Mo) derivative increasing gradually or sequentially, and/or having surface energy decreasing gradually or sequentially, and accordingly, bending or leaning of the semiconductor pattern AP may be reduced, and a void or a seam may not be formed in the process of forming the word line conductive layer 140. Therefore, the word line conductive layer 140 may have a relatively low resistivity and simultaneously prevent the occurrence of filling defects such as, but not limited to, a void and/or a seam in the process of forming the word line conductive layer 140.

The semiconductor memory device may include a word line including molybdenum (Mo)-based metal and including first to third conductive layers having different contents of the additive element. The word line may have a relatively low resistivity. In addition, the word line may have a surface energy that gradually decreases toward the outside, which may prevent bending or leaning of the semiconductor pattern from occurring in a process of forming the word line, and preventing a void or a seam from forming in the word line. The semiconductor memory device may have an increased memory capacity and improved electrical characteristics, when compared to a related semiconductor device.

## Claims

1. A semiconductor memory device, comprising:
a plurality of semiconductor patterns (AP) extending in a first horizontal direction (X) on a substrate (110), spaced apart from each other in a second horizontal direction (Y) crossing the first horizontal direction (X) and a vertical direction (Z), and each of the plurality of semiconductor patterns (AP) comprising a first end portion and a second end portion;
a plurality of bit lines (BL) extending in the vertical direction (Z), each of the plurality of bit lines (BL) coupled with the first end portion of each of the plurality of semiconductor patterns (AP);
a plurality of word lines (WL) extending in the second horizontal direction (Y) and at least partially surrounding the plurality of semiconductor patterns (AP), respectively, each of the plurality of word lines (WL) comprising a first conductive layer (142) comprising a first molybdenum, Mo, derivative having a first composition, a second conductive layer (144) comprising a second molybdenum, Mo, derivative having a second composition different from the first composition, and a third conductive layer (146) comprising a third molybdenum, Mo, derivative having a third composition different from the second composition; and
a plurality of cell capacitors (CAP), each of the plurality of cell capacitors being coupled with the second end portion of each of the plurality of semiconductor patterns (AP).

2. The semiconductor memory device of claim 1, wherein the first molybdenum, Mo, derivative is expressed as a chemical formula of MoM_{3z},
wherein M₁ comprises at least one of oxygen, O, chlorine, Cl, nitrogen, N, hydrogen, H, carbon, C, or silicon, Si, and
wherein x represents an atomic percentage, at%, greater than or equal to 0.01 at% and less than or equal to 20 at%.

3. The semiconductor memory device of claim 1 or 2, wherein the second molybdenum, Mo, derivative is expressed as a chemical formula of MoM_{2y},
wherein M₂ comprises at least one of oxygen, O, chlorine, Cl, nitrogen, N, hydrogen, H, carbon, C, or silicon, Si, and
wherein y represents an atomic percentage, at%, greater than or equal to 15 at% and less than or equal to 40 at%.

4. The semiconductor memory device of any one of claims 1 to 3, wherein the third molybdenum, Mo, derivative is expressed as a chemical formula of MoM_{3z},
wherein M₃ comprises at least one of oxygen, O, chlorine, Cl, nitrogen, N, hydrogen, H, carbon, C, or silicon, Si, and
wherein z represents an atomic percentage, at%, greater than or equal to 40 at% and less than or equal to 85 at%.

5. The semiconductor memory device of any one of claims 1 to 4, wherein a second surface energy of the second molybdenum, Mo, derivative is lower than a first surface energy of the first molybdenum, Mo, derivative, and
wherein a third surface energy of the third molybdenum, Mo, derivative is lower than the second surface energy.

6. The semiconductor memory device of any one of claims 1 to 5, further comprising:
a gap-fill insulating layer between two adjacent word lines (WL) from among the plurality of word lines (WL); and
a gate insulating layer (GI) between the gap-fill insulating layer and the plurality of word lines (WL) and between the plurality of semiconductor patterns (AP) and the plurality of word lines (WL).

7. The semiconductor memory device of claim 6, wherein each of the plurality of word lines (WL) further comprises a barrier metal layer (BM) between the gate insulating layer (GI) and the first conductive layer (142).

8. The semiconductor memory device of claim 7, wherein the barrier metal layer (BM) comprises at least one of titanium, Ti, titanium nitride, TiN, titanium aluminum carbide, TiAlC, titanium aluminum nitride. TiAlN, titanium silicon nitride, TiSiN, molybdenum silicon nitride, MoSiN, tungsten nitride, WN, tungsten silicon nitride, WSiN, tantalum, Ta, tantalum silicon nitride, TaSiN, tantalum nitride, TaN, or lanthanum nitride, LaN.

9. The semiconductor memory device of any one of claims 6 to 8, wherein the gate insulating layer (GI) is in direct contact with an upper surface, a bottom surface, and a sidewall of each of the plurality of semiconductor patterns (AP), and
wherein the first conductive layer (142) at least partially surrounds the upper surface, the bottom surface, and the sidewall of each of the plurality of semiconductor patterns (AP) on the gate insulating layer (GI).

10. The semiconductor memory device of claim 9, wherein the second conductive layer (144) at least partially surrounds the upper surface, the bottom surface, and the sidewall of each of the plurality of semiconductor patterns (AP) on the first conductive layer (142), and
wherein the third conductive layer (146) at least partially surrounds the upper surface, the bottom surface, and the sidewall of each of the plurality of semiconductor patterns (AP) on the second conductive layer (144).

11. The semiconductor memory device of any one of claims 1 to 10, wherein each of the plurality of word lines (WL) comprises:
a plurality of main conductive regions (MP) at least partially surrounding the plurality of semiconductor patterns (AP) at positions at least partially overlapping vertically the plurality of semiconductor patterns (AP) ; and
a connection region (CP) between two adjacent semiconductor patterns (AP) from among the plurality of semiconductor patterns (AP) and coupled with the plurality of main conductive regions (MP), and
wherein an upper surface of the connection region (CP) is at a lower vertical level than upper surfaces of each of the plurality of main conductive regions (MP).

12. The semiconductor memory device of any one of claims 1 to 10, wherein the plurality of semiconductor patterns (AP) comprise a first semiconductor pattern and a second semiconductor pattern spaced apart from the first semiconductor pattern in the second horizontal direction (Y),
wherein the plurality of word lines (WL) comprise a first word line extending in the second horizontal direction (Y) and at least partially surrounding the first semiconductor pattern and the second semiconductor pattern, and
wherein the first word line comprises:
a first main conductive region at least partially surrounding the first semiconductor pattern;
a second main conductive region at least partially surrounding the second semiconductor pattern; and
a connection region (CP) disposed between the first main conductive region (MP)and the second main conductive region.

13. The semiconductor memory device of claim 11 or 12, wherein the connection region (CP) does not comprise at least one of a void or a seam therein.

14. The semiconductor memory device of any one of claims 1 to 13, wherein each of the plurality of word lines (WL) further comprises a fourth conductive layer (149; 149A) on the third conductive layer (146), and
wherein the fourth conductive layer (149; 149A) comprises at least one of titanium nitride, TiN, titanium silicon nitride, TiSiN, molybdenum silicon nitride, MoSiN, or molybdenum silicon nitride hydride, MoSiNH.

15. The semiconductor memory device of any one of the preceding claims, wherein:
the first molybdenum, Mo, derivative comprises a first additive element in a first content,
the second molybdenum, Mo, derivative comprises a second additive element in a second content greater than the first content, and
the third molybdenum, Mo, derivative comprises a third additive element in a third content greater than the second content.
